# EUROPEAN PATENT SPECIFICATION

(11) **EP 1 547 143 B1**
(45) Date of publication and mention of the grant of the patent: **13.10.2010**
(21) Application number: 03784416.4
(22) Date of filing: 11.08.2003
(51) Int. Cl.: H01L 21/66

(54) **A METHOD OF PREPARING A THIN LAYER, THE METHOD INCLUDING A STEP OF CORRECTING THICKNESS BY SACRIFICIAL OXIDATION, AND AN ASSOCIATED MACHINE**
VERFAHREN ZUR HERSTELLUNG EINER DÜNNEN SCHICHT, EINSCHLIESSLICH EINES SCHRITTES DES KORRIGIERENS DER DICKE DURCH HILFSOXIDATION UND ZUGEHÖRIGE VORRICHTUNG
PROCEDE DE PREPARATION D'UNE COUCHE MINCE, LEDIT PROCEDE COMPRENANT UNE ETAPE DE CORRECTION DE L'EPAISSEUR PAR OXYDATION SACRIFICIELLE ET MACHINE ASSOCIEE

(30) Priority: 12.08.2002 FR 0210208; 12.08.2002 FR 0210209; 30.04.2003 US 467241 P
(43) Date of publication of application: 29.06.2005
(60) Divisional application: 10155844.3
(73) Proprietor: S.O.I.Tec Silicon on Insulator Technologies, 38190 Bernin (FR)
(72) Inventor: GHYSELEN, Bruno, F-38170 Seyssinet-Pariset (FR); AULNETTE, Cécile, F-38000 Grenoble (FR); OSTERNAUD, Bénédite, 38380 Saint Laurent du Pont (FR)
(74) Representative: Le Forestier, Eric
(86) International application number: PCT/IB2003/003640
(87) International publication number: WO 2004/015759

(56) References cited:
- EP-A- 0 881 040
- WO-A-00/60657
- WO-A-02/25708
- FR-A- 2 797 714
- US-A- 6 096 233

## Description

The present invention relates to fabricating semiconductor components for microelectronics and/or optoelectronics.

More precisely, the invention applies in the fabrication and/or preparation of thin layers for making such components, by measuring the thickness of said layers and then taking action to correct thickness.

Even more precisely, according to a first main aspect, the invention relates to a method according to claim 1.

The invention also relates to an associated apparatus.

Thin layers as mentioned above are made at the end of a fabrication facility comprising a plurality of successive steps.

The Smart-Cut^{®} method is an example of such a method of fabrication.

A general description of said method is to be found in the work "Silicon-on-insulator technology: materials to VLS", 2nd edition by Jean-Pierre Colinge, (see pages 50 and 51 in particular).

Such a method enables thin layers and films of semiconductor material to be obtained. One variant of said method comprises the following steps.

During a first step, at least one face of a wafer of semiconductor material is oxidized.

During a second step, a zone of weakness is created beneath a face of the wafer by ion implantation.

During a "bonding", third step, said face of the wafer is put into close contact with a supporting substrate and is secured thereto.

During a fourth step, the assembly constituted by the wafer and the supporting substrate is subjected to treatment suitable for creating detachment in the wafer at the zone of weakness.

During a fifth step, finishing techniques on the implantation face of the portion comprising the substrate are implemented, in particular to reduce the defects generated by the detachment, and/or to return to a level of roughness that is low enough.

By way of illustration, examples of finishing techniques can be found in document FR 2 797 713 which teaches a technique implementing annealing, and document FR 2 797 714 which teaches a technique implementing polishing and oxidizing steps.

The Smart-Cut^{®} method thus makes it possible to make multilayer silicon-on-insulator (SOI) type structures by retaining a layer of oxide as created during the first step on the implantation face of the wafer so that during the bonding step, the layer of oxide is interposed between the supporting substrate and the wafer.

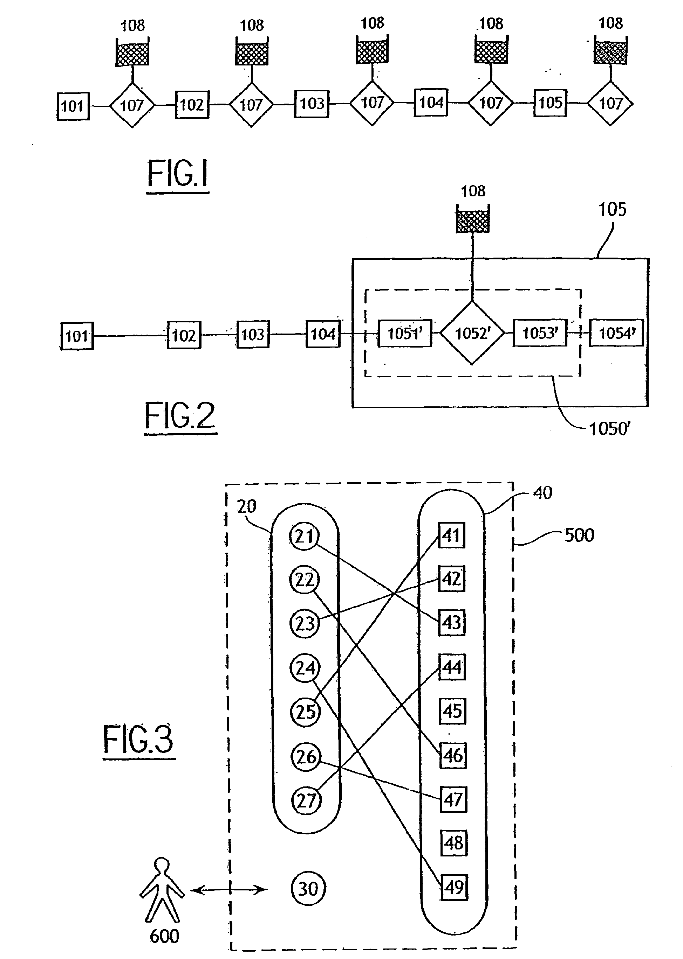

In a particular implementation of the Smart-Cut^{®} method, the steps 101 to 105 of fabricating an SOI structure are as shown in Figure 1. They are described below.

It is specified that other types of method also exist enabling SOI structures to be fabricated.

Whatever the type of method implemented, each new step included in a fabrication facility necessarily requires handling of and/or intervention on the layers, thus leading to additional risks of fabrication defects.

One type of fault relates to a layer having thickness that departs from the thickness specifications required by the manufacturer. Layers can be rejected because of defects resulting in the thickness of the layer not corresponding to the thickness specifications, in particular in terms of:
· mean thickness of the layer; and/or
· non-uniformity of thickness within a given layer (often referred to as failure to satisfy the requirement for "within wafer" uniformity).

Layers are usually fabricated in batches, and it is also desirable to satisfy specifications for uniform thickness between the various layers of a given batch (referred to as "wafer-to-wafer" uniformity).

The batches may correspond to layers that have been subjected to the same fabricating steps, under the same conditions (same annealing, etc....).

Batches may also correspond to a group of layers defined in some arbitrary way, e.g. they may correspond to production over a given time interval (one day or some other time interval).

In practice, it is often desirable, at the end of fabrication, to achieve the same average thickness for all the layers of the batch (within some given tolerance - typically said tolerance is a few percent).

It is also generally desirable to achieve "batch-to-batch" uniformity between the layers of various batches, when the final thickness specifications (represented by an average thickness value, for example) are the same for the layers of various batches.

Thickness inspection steps implementing techniques for measuring the thicknesses of thin layers are therefore generally associated with certain steps for processing the layers, all along the fabrication facility.

These inspection steps imply that layers will be rejected if they present thickness defects that are harmful to the proper operation of future electronic components.

Returning to the example of the main steps in a Smart-Cut^{®} type method for preparing SOI as shown in Figure 1, the thickness inspection steps are represented diagrammatically by lozenges 107 and they are situated downstream from each step in the method of preparing SOI: after the oxidizing step 101; after the ion implantation step 102; after the bonding step 103; after the heat treatment step 104; and after the finishing step 105.

It should be understood that the configuration shown in Figure 1 is a "maximalist" version of the implementation of thickness inspection steps 107. In reality, thickness inspection steps are not associated with each step in the method of preparing SOI, but only with some of said steps.

Providing the thickness measured on a layer is satisfactory, then the layer moves on to the following step. Otherwise the element is rejected and scrapped at 108.

That conventional type of method including multiple steps of layer thickness inspection leads to material being lost, and also to a consequent reduction in the rate of throughput of the fabrication facility as a result of the need to inspect very closely the fabrication steps which affect the thickness of the layers.

One solution for reducing those drawbacks would be to eliminate the various successive inspections of thickness, or to relax the constraints associated therewith by including a thickness correcting step at the end of fabrication.

It would then be possible to relax the constraints associated with the various steps of the layer fabrication process, thereby simplifying and accelerating the operation of said process.

For this purpose, it is important to implement methods and apparatuses that correct thickness in a manner that is effective and accurate, particularly since the thicknesses of thin layers are becoming smaller year on year with the improvements that are being made to layer-preparation techniques.

### First main aspect: simultaneous layer thickness correction

A first attempt at satisfying this need is proposed by the so-called plasma assisted chemical etching (PACE) method described in the document "Semiconductor wafer bonding: science and technology", by Q.Y. Tong and U. Gösele.

The main steps of the PACE method are, in outline, as follows:

After acquiring thickness measurements of a thin layer by means of an optical reflection technique, a control unit responds to the measurements it receives by deducing specifications for correcting the thickness of the layer.

The thickness correction apparatus receives the thickness correction specifications from the control unit and then corrects the thickness defects of the layer in application of the specifications.

The thickness correction apparatus implemented by the PACE method uses the plasma assisted chemical etching technique. That technique is based on using a chemical etching technique that is localized relative to the layer.

A tool applying such techniques is thus suitable for removing material from the layer.

Since the tool removes material from an area that is much smaller than the area of the layer, thickness correction is thus performed locally on the layer.

Since the tool is also suitable for moving over the layer, it thus travels over all or part of the layer following a path that comprises a plurality of sequences, each lasting for a certain length of time.

It is the layer correction specifications previously generated by the control unit that define the path sequences and the etching times. Such specifications are directly linked with a map of thicknesses as deduced from the measurements performed on the layer.

That method of thickness reduction thus seeks to apply treatment that is adapted to the thickness characteristics of each fabricated layer, and to perform individual repair operations on each layer.

The PACE method relating to the thickness correction apparatus using the plasma assisted chemical etching technique nevertheless suffers from several drawbacks.

Firstly, the conditions under which such technology are implemented are highly constraining.

The reaction chamber in which etching is implemented is dirtied by the etching operations and therefore requires frequent maintenance.

The need to establish a vacuum in the reaction chamber is an additional constraint in terms of implementing such a method, since a high vacuum requires large and expensive pumping means, significant sealing means, and high-performance monitoring means.

Secondly, the very principle of moving the tool that removes material over the layer along a path that is associated with locally removing material by etching leads to treatment of the layer being lengthy and laborious.

Including such a step of treating layers by etching in a facility for mass producing thin layers is therefore difficult since the rate at which thin layers enter and leave the etching chamber slows production down.

Thirdly, plasma assisted chemical etching technology itself suffers from drawbacks, some of which are further amplified when it comes to treating very thin layers.

As mentioned above, it is desirable to fabricate layers of ever decreasing thickness, making it more and more important to control the quantity of material that is removed very finely.

In particular, exposing a thin layer to a plasma in a highly reactive environment can lead to defects being created in the crystal structure and to charge accumulating within the layer, with this being particularly harmful when the layer is thin.

This limitation means that PACE applications are limited in practice to layers having an average thickness of more than 1 micrometer (µm).

The resolution of the PACE technique is limited in practice to accuracy over the thickness that is finally obtained that is of the order of a few hundreds of angstroms (Å). This accuracy thus makes it possible to produce layers having thickness of the order of 1 µm with precision of the order of a few percent.

However, with very thin layers, where the desired thickness may be of the order of 1000 Å, for example, tolerance of a few percent in the final thickness corresponds to resolution of a few tens of angstroms, and that cannot be envisaged with the above-mentioned PACE technique.

That technique is therefore unsuited to correcting the thickness of thin layers when the mean thickness thereof is less than a value of 1 µm.

Finally, it should be added that it is very difficult to control the characteristics of the plasma implemented in PACE in such a manner as to treat substrates of large dimensions.

It thus appears that the attempted solution corresponding to the PACE method suffers from numerous limitations.

A second attempt at satisfying the need to implement methods and apparatuses for correcting thickness in effective and accurate manner is also known.

Patent document WO 01/83238 in the name of Epion Corporation discloses an example of the second type of technique.

However in that case also, some of the limitations mentioned above with respect to the PACE technique continue to apply.

In particular, the technique proposed by Epion is also expensive and complex to implement.

It is necessary in that case also to establish a vacuum in the reaction chamber.

Another major limitation of that second type of technique is again that individualized treatment is performed sequentially on different zones of a layer, which leads to treatment times that are lengthy.

An additional drawback associated with that second type of technique is that it does not make it possible to achieve levels of roughness that are small enough for the intended applications, in particular when fabricating SOI.

As described below and in contrast, the present invention proposes a technique that makes it possible to treat the entire surface of a layer simultaneously and in differential manner depending on the location of the layer under consideration, and it does so in such a manner that leads to roughness that is very small, equivalent in level to the roughness that can be obtained with a polishing operation.

The term "simultaneously" is used to mean that the various zones of the surface of the layer are treated at the same time.

It is to be noted that there are known method and apparatuses to perform the acquisition of data related to wafers, such as a data representing a layer thickness.

An example of such method / apparatus is provided by document WO-02 25708.

But this document does not provide any information about how to use such data to correct the thickness of the layer in its entire surface, simultaneously.

Thus, the various attempts mentioned above suffer from limitations.

A first object of the present invention is to overcome those limitations.

In order to achieve this object, the invention provides, in a first particular aspect of the first main aspect of the invention, a method of preparing a thin layer of semiconductor material, the method including a step of correcting the thickness of the layer, said step of correcting thickness of the layer itself comprising the following operations:
acquiring a measured thickness profile of the layer;
deducing thickness correction specifications from the measured thickness profile; and
correcting the thickness of the layer in accordance with said specifications;
the method being **characterized in that** thickness correction implements a technique which simultaneously treats the entire surface of the layer, while locally and selectively adapt layer thickness in different regions of the layer surface.

Preferred but non-limiting aspects of the method of this particular aspect of the invention are as follows:
· the technique for correcting the thickness implements sacrificial oxidation;
the thickness correction specifications correspond to uniform thickness correction over the surface of the layer to be prepared;
thickness correction specifications correspond to differential thickness correction over the surface of the layer to be prepared;
the thickness correction specifications correspond to uniform thickness correction over the surface of the layer to be prepared in combination with differential correction thickness over the surface of the layer to be prepared;
the thickness correction specifications are established in such a manner as to produce a layer whose thickness is as constant as possible over the entire layer;
· during thickness corrections, the entire surface of the layer is treated simultaneously;
layers are prepared in batches of layers;
layer thickness correction is performed on batches of layers;
· the layers of a batch are organized in a succession of layers, with the thickness of one layer in the batch being measured while the thickness of a preceding layer in the same batch is being corrected;
· for all of the layers of the batch, a single target thickness profile is defined, and the respective thickness correction specifications for each of the layers of the batch are individualized in such a manner that, once thickness correction has been performed, each layer of the batch has a final layer thickness profile that is close to the target thickness profile;
· for all of the layers of the batch, a single target thickness profile is defined, and the thickness correction specifications of all of the layers of the batch are the same, as a function of at least one thickness measurement performed on a layer of the batch;
· the target thickness profile consists in a target value, said target value designating a single target thickness to be achieved over the entire surface of each of the layers of the batch;
· the operation of acquiring a measurement is performed by an ellipsometer;
· the operation of acquiring a measurement is performed by a reflectometer;
· the sacrificial oxidation is implemented by a thermal oxidation technique;
· the sacrificial oxidation is implemented by a rapid thermal oxidation technique;
· during sacrificial oxidation, means are implemented for selectively oxidizing different locations of the layer;
· during sacrificial oxidation, apparatus is implemented including a plurality of heater lamps situated facing different locations of the layer and capable of being powered selectively so as to adjust locally the temperature at which the layer is oxidized; and
· the method also implements the main steps of a Smart-Cut^{®} method.

In a second particular aspect of the first main aspect, the invention also provides the use of a method as specified above for fabricating a layer of semiconductor material in a multilayer structure.

Preferred but non-limiting aspects of such a use are as follows:
· said layer is made of silicon; and
· the multilayer structure is an SOI structure.

In a third particular aspect of the first main aspect, the invention provides a machine for implementing a method in accordance with any one of the above aspects, **characterized in that** it comprises means for acquiring a thickness profile measurement for a layer, and means for correcting layer thickness by sacrificial oxidation.

Preferred but non-limiting aspects of such a machine are as follows:
· the machine further comprises a processor unit connected to the measurement acquisition means and to the thickness correction means;
· said means for acquiring a thickness profile measurement, said thickness correction means, and said processor unit are integrated in the machine;
· the means for acquiring a thickness measurement implements a reflectometer;
· the means for acquiring a thickness measurement are of the Acumap^{™} type;
· the thickness correction means are suitable for treating the thickness of the entire surface of at least one layer simultaneously in selective manner;
· the thickness correction means are adapted to correct the thickness of a single layer at a time;
· the thickness correction means are of the RTP XE Centura^{™} type;
· the thickness correction means enable the thickness of entire batches of layers to be corrected; and
· the thickness correction means is a tube oven.

As explained below and as will be apparent from the description, the method of the invention as mentioned above makes it possible in particular to achieve the following objectives:
· increasing the productivity of the facility for preparing thin layers, in particular by making it possible to eliminate the intermediate thickness inspection operations and by treating each layer in a single operation;
· relaxing the constraints associated with the layer fabrication step, thereby also having the effect of increasing yield;
· correspondingly reducing rejects;
· improving the quality of thin layers by reaching thickness values that are closer to the required specifications, but without that harming the crystal quality of the layer; and
· correcting layer thickness defects for layers presenting mean thicknesses of less than 1 µm, possibly it being of the order of 0.1 µm, for example, or even of the order of 0.1 µm.

### Second main aspect: elaboration of thickness correction specification

As mentioned above, layers can be rejected because of defects concerning the mean thickness of the layer, and / or a poor uniformity of the thickness within a given layer.

Layers are usually fabricated in batches, with the same target thickness being required for all of the transferred layers of a batch (within a given tolerance).

As a result, it is also desirable to satisfy specifications for uniform thickness between the various layers of a given batch (referred to as "wafer-to-wafer" uniformity).

To achieve wafer to wafer and within wafer optimal thickness, a thickness correction might comprise the following operations on each layer :
· acquiring at least one measurement of layer thickness;
· determining specifications for correcting thickness that need to be applied to the layer as a function of the acquired thickness measurement(s); and
· correcting the thickness of the layer in application of said correction specifications.

One even envision to calculate "personalized" thickness correction specifications for each layer as a function of the measurements on the layer and as a function of the target thickness desired for the layer.

Such calculation would then to be repeated for each layer, in order to create new thickness correction specifications for each layer.

However, that would correspond to a quantity of calculation that is not needed in some cases.

In particular, when fabricating layers in batches, the layers within a given batch may present, prior to correction, thicknesses that are relatively similar, because the layers in the batch have generally all been subjected together to the same prior steps in the method of preparation (annealing, etc....).

Under such circumstances, repeating calculations in full so as to create individual specifications for each new layer in the batch can correspond to a waste of calculation resources and of time.

More generally, it may be desirable to cut down and simplify the operation of determining the thickness correction specifications that are to be applied to each layer.

Although the targets in terms of layer thickness are strict, they nevertheless allow a certain amount of tolerance.

It is therefore not really necessary to create individualized thickness correction specifications for each layer, provided that the correction specifications associated with each layer enable a thickness correction operation to be undertaken that enables the target thickness to be reached, within tolerances.

Another object of the invention, according to a second main aspect, is to provide advantageous means to perform such correction.

To achieve this object, in a first particular aspect of said second main aspect, the invention provides a method of correcting the thickness of a thin layer of semiconductor material, the method comprising the following operations:
· acquiring at least one thickness measurement of the layer;
· determining thickness correction specifications to be applied to the layer as a function of the acquired thickness measurement(s); and
· correcting the thickness of the layer in accordance with said correction specifications;
   the method being **characterized in that** determining the correction specifications comprises:
· establishing a thickness profile of the layer on the basis of the acquired thickness measurements;
· comparing said profile with stored typical profiles, each typical profile being stored in association with respective thickness correction specifications (or recipes); and
· selecting a stored typical profile in order to associate a layer whose thickness is to be corrected with the thickness correction specifications that are stored in association with the selected typical profile.

Preferred but non-limiting aspects of such method are as follows:
· the method includes a configuration step enabling associations to be established between the stored typical profiles and the recipes;
· said configuration is implemented by an algorithm having, as an item of input data, a target specification for thickness profile (i.e. a "target") established for layer fabrication;
· the thickness measurements, the typical profiles, and the target are defined using identical meshes;
· on each change of target, the configuration algorithm is automatically reactivated to establish a new configuration defining correspondences between the typical profiles and the recipes;
· the method includes storing at least one configuration;
· the method includes storing a plurality of configurations, and selecting a desired configuration;
· the typical profiles and/or the recipes are classified in a tree structure defining categories and sub-categories with a desired number of levels;
· zones of the typical profile tree structure can be selected within which to undertake a search in order to select a typical profile;
· the recipe tree structure is defined by finer and finer levels of detail going deeper into the tree structure;
· in order to establish a configuration, the configuration algorithm searching for a recipe to associate with a typical profile does not search through all of the recipes, but begins by selecting categories of

recipes as a function of thickness differences between the target and the typical profile;
· for configuration purposes, a link is established between a given level of a typical profile tree structure ("starting level") and a given level of a recipe tree structure ("arrival level"), such that for each typical profile belonging to a given category of starting level, there exists an arrival level category of recipes, and during configuration, all searching for a recipe for a typical profile at this starting level is automatically directed towards said arrival level category, searching then continuing by going deeper into the recipe tree structure;
· the recipe tree structure is defined by recipe parameters;
· the high level categories of recipes in the recipe tree structure comprise:
   ➢ a first high level recipe category defining a uniform thickness correction specification for the entire surface of the layer; and
   ➢ other high level categories depending on overall distribution parameters for thickness correction specifications over said surface;
· the thickness correction is applied simultaneously to the entire surface of a layer, with it being possible to cause said correction to differ depending on location on the surface of the layer;
· the layer thickness correction makes use of sacrificial oxidation;
· layers are treated in batches, the thickness of one layer in a batch being measured while correcting the thickness of a layer in said batch preceding said measured layer by a given pitch;
· the layers in a given batch share the same final target thickness, and the recipe for each layer is individualized in such a manner as to ensure that once thickness correction has been performed, a mean layer thickness is obtained for the batch that is as close as possible to the common target;
· the recipes correspond to thickness modification that is uniform over the entire layer; and
· the recipes correspond to differential thickness modification over the surface of the layer.

In a second particular aspect of its second main aspect, the invention also provides apparatus for implementing a method of the above-specified type, the apparatus being **characterized in that** it comprises:
· thickness measuring means;
· thickness correction means; and
· a processor unit associated with means for storing thickness correction specifications, and connected to the thickness measuring means to receive therefrom measurements made on the layers, and also to the thickness correction means to forward thereto thickness correction specifications.

Other preferred but non-limiting aspects of such apparatus are as follows:
· the thickness measuring means comprise an ellipsometer;
· the thickness measuring means comprise a reflectometer;
· the thickness measuring means comprise apparatus of the Acumap^{™} type; and
· the thickness correction means comprise apparatus of the RTP XE Centura^{™} type.

Other aspects, objects, and advantages of the invention appear on reading the following detailed description made with reference to the accompanying drawings in which:
· Figure 1, described in the introduction, represents diagrammatically the steps in a method of preparing SOI structures in the art prior to the present invention;
· Figure 2 is a diagram showing the steps of a variant of the present invention of a method of preparing SOI structures of the Smart-Cut^{®} type;
· Figure 3 is a diagram showing an example of association established between two types of parameter which can be stored in order to implement the invention during the operation of deducing thickness correction specifications from the operation of measuring a thin layer;
· Figure 4 is a diagram showing the use which is made of the association mentioned above with reference to Figure 3;
· Figure 5 is a diagram showing the steps of sacrificial oxidizing of a thin layer on a substrate;
· Figure 6 is a perspective view of a rapid thermal oxidation (RTO) device implemented in the invention for correcting thickness;
· Figure 7 is a diagrammatic cross-section view of a thermal oxidation chamber of an RTO device, at atmospheric pressure;
· Figure 8 is a diagrammatic cross-section view of a thermal oxidation chamber of an RTO device at low pressure;
· Figure 9 is a diagram showing how the lamps and probes surrounding thin layers that can be of different diameters are distributed within an RTO device;
· Figure 10 is a block diagram showing how an RTO device operates;
· Figure 11 is a graph showing how the thicknesses of silicon oxide layers formed by RTO increase over time for different concentrations of H₂ in the oxidizing gas at low pressures and with an oxidation temperature set at 1050°C;
· Figure 12 shows how the thicknesses of silicon oxide layers formed by RTO at different oxidation temperatures increase over time when oxidation is performed at a pressure of 10 torr and at a concentration of H₂ set at 33% of the oxidizing gas;
· Figure 13 is a diagram comparing layer thicknesses between a batch of layers that have not been subjected to thickness correction (13 a), and of the same batch after sacrificial oxidation treatment, in two different implementations (respectively 13 b and 13 c); and
· Figure 14 shows silicon oxide thicknesses, and the associated tolerances as formed by RTO on 700 thin layers, under dry oxidation at 110°C and in a time of 60 seconds (s).

Before embarking on the description below, it is specified that the term "thin layer" is used herein to mean a layer of material presenting thickness that may lie in the range of a few angstroms to a few tens of micrometers.

Such a thin layer is typically made of a semiconductor material such as silicon, preferably by a Smart-Cut^{®} method.

Nevertheless, it is specified that such a layer can also be obtained as follows:
· by a deposition technique (e.g. of polycrystalline silicon), or by an epitaxial growth technique (e.g. of monocrystalline silicon); or
· by a layer transfer technique other than the Smart-Cut^{®} technique. In this respect, the transfer technique may in particular be a technique implementing creation of a zone of weakness in a substrate of semiconductor material, followed by detachment at said zone in order to make the layer. It is further specified that:
   ➢ the semiconductor material may be silicon. In which case the layer may correspond to an SOI surface layer; and
   ➢ the transfer technique, in addition to a technique of the Smart-Cut^{®} type, may be constituted, for example, by a technique of Eltran^{®} type or by some other type of transfer technique.

In any event, the material of the layer is preferably a material capable of being oxidized (e.g. of the silicon type, but other materials can be envisaged: for example SiC, SiGe, ...).

This thin layer is advantageously secured to a support referred to as a "substrate" which serves in particular to stiffen the assembly comprising the layer and the substrate (also known as a "wafer").

The substrate may advantageously comprise a semiconductor (e.g. silicon), or a stack of semiconductor layers, or indeed of non-homogenous components or of components or of parts of components at more or less advanced stages of preparation.

With reference now to Figure 2, there is shown an example of the method of the invention for preparing thin layers implementing the main steps of the Smart-Cut^{®} method.

In this example, the thin layers are layers of silicon for SOI.

Nevertheless, the invention is applicable to preparing any type of thin layer, including layers, e.g. silicon layers, made by epitaxial growth (in particular monocrystalline silicon), or indeed by deposition (in particular polycrystalline silicon).

Nor is the invention limited to a variant of a Smart-Cut^{®} type method, but on the contrary it applies to any type of method for preparing thin layers.

Still with reference to Figure 2, it can be seen that compared with the scheme shown in Figure 1, the thickness inspection steps 107 have been omitted, thus avoiding the resulting multiple losses and slowdowns of that scheme.

As a result, it is also possible to relax the constraints associated with the various steps of fabricating layers, since a final thickness correction step is provided, as described below.

Nevertheless, it is also specified that one or more intermediate inspection steps 107 could be retained in certain variants of the invention, depending on the specific needs of the method.

In the context of the invention, it is during finishing (referenced 105' herein) that action is taken to inspect layer thickness.

As shown in Figure 2, finishing 105' includes a thickness correction step 150', which itself comprises three operations applied to each layer:
· the operation 1051' of acquiring at least one measured thickness profile of the layer;
· the operation 1052' of deducing correction thickness specifications to be applied to the layer on the basis of the measured thickness profile acquired in 1051'; and
· the operation 1053' of correcting layer thickness in accordance with said specifications.

It is specified that the term "profile" is used to mean a representation of thickness characteristic of a layer.

Such a profile may be constituted by a two-dimensional mesh covering the entire surface of the layer. Under such circumstances, a measured thickness profile of the layer consists in a series of measurements performed at the nodes of the mesh.

Nevertheless, it is possible to adapt the definition of a profile as a function of the capacity of the machines, in particular in terms of desired level of detail and in terms of desired rates of throughput to be obtained.

It is thus possible to define a "profile" in its simplest form as being a single measured point.

As mentioned below, the notion of "profile" relates not only to the measurements performed on the layers, but also to the thickness correction specifications which are transmitted to the thickness correction means for implementing the operation 1053'.

The thickness correction operation 1053' implements sacrificial oxidation, as described in greater detail below.

The thickness correction step 1050' may be followed by an additional finishing step 1054', e.g. implementing annealing under hydrogen.

Figure 2 also shows a scrapping step 108 which may possibly follow the operation 1052' of deducing specifications, in the event of the measured thickness profile of the layer as acquired in 1051' being unsuitable for enabling adequate correction to be applied to the layer in order to obtain a desired layer thickness profile at the outlet of the method.

### Measurement profile acquisition

After creating thin layers during steps 101 to 104 (which are identical to those described with reference to Figure 1), each thin layer is finished in step 105'.

To do this, a step 1050' is performed initially.

Each step 1050' begins by an operation 1051' of acquiring at least one thickness measurement of a previously prepared layer, e.g. by means of a reflectometer or by means of an ellipsometer.

This acquisition of layer thickness measurements may be implemented by means of apparatus such as an Acumap^{™} reflectometer from the supplier ADE.

At the end of operation 1051', a thickness profile is available for each thin layer in the form of a map of the thickness of the layer.

In a batch fabrication context, it is thus possible to measure the thickness of one layer in the batch simultaneously applying the subsequent operation 1053' of thickness correction as described below to an earlier layer in the batch (either to the immediately preceding layer of the batch, or else to a layer preceding by some determined numbers of intervening layers).

In any event, the measured profile is forwarded by the thickness measurement apparatus to a treatment unit which may also be connected to memory means suitable for storing the measured profiles of the layers.

In this respect, it is specified that the apparatus for implementing the invention thus comprises:
· thickness measuring means which may be constituted as mentioned above by an Acumap^{™} type machine;
· thickness correction means, described in greater detail below; and
· a processor unit associated with memory means (or "memory"), and connected to the thickness measuring means (to receive therefrom measurements made on the layers), and to the thickness correction means (to forward thereto the thickness correction specifications).

It is also specified that the invention can be implemented in fully automated manner in which the various above-mentioned means (thickness measuring means, thickness correcting means, processor unit) are connected to one another and are suitable for exchanging information automatically.

Under such circumstances, the machine automatically determines the "recipes" to be applied as a function of the thickness measurements made on the layers (the concept of "recipes" is explained below).

Nevertheless, it is also possible to implement the invention in simplified manner in which said three means are not necessarily interconnected.

In a particularly simple implementation of the invention, the apparatus does not include a processor unit, but merely comprises thickness measuring means and thickness correcting means.

In such a simplified implementation, an operator observes the thickness measurements made on the layers, e.g. in real time, and issues the thickness correction commands to the thickness correcting means, with the thickness corrections for application being deduced by the operator as a function of the observed thickness measurements.

### Deducing thickness correction specifications

The next operation 1052' consists in deducing thickness correction specifications from the thickness measurement profile.

It is this operation which serves to transform the thickness measurements performed on each layer into commands applied to the thickness correcting means.

With reference to Figure 3, this operation of deducing thickness correction specifications preferably makes use of a "library" 40 of typical thickness correction specifications 41 to 49 (referred to as "recipes" herein), which are stored in permanent manner in the above-mentioned memory means referenced 500.

The use of a library is in any case embodied according to the second main aspect of the invention.

Each recipe is a set of specifications to be delivered to the thickness correcting apparatus, which specifications are implemented during the operation 1053' in order to control the action of said apparatus.

It is specified that although the recipes are stored in permanent manner in the memory means 500, these recipes can nevertheless be varied over time: in particular, an operator can update the recipes in the memory 500 as often as necessary.

In this case, the operation 1052' thus consists in selecting the most suitable recipe from amongst the recipes stored in the library 40.

This selection can be performed in various ways.

In one implementation, such a selection is performed by using a list 20 of typical thickness profiles (21 to 27 in the example of Figure 3).

As shown in Figure 3, correspondances are established between the typical thickness profiles and the recipes. More precisely, each typical profile is associated with a single recipe.

The set of associations between typical profiles and recipes defines a "configuration" of the processor unit.

It is specified that for a given configuration, a plurality of typical profiles may be associated with a single recipe.

The configuration made up of associations between typical profiles and recipes are also stored in the memory 500.

The invention can be implemented in fully automatic manner; the configuration can then be established automatically by a "configuration" algorithm which is loaded into the processor unit.

More precisely, one of the data items input into the configuration algorithm is the target specification of the thickness profile (referred to as the "target" below) that has been established for layer fabrication.

The target may be modified from time to time by an operator 600 using input means associated with the processor unit.

In any event, the target is stored in the memory 500 (where it is referenced 30).

For each change of target, the above-mentioned configuration algorithm is automatically reactivated in order to establish a new configuration defining correspondances between typical profiles in the list 20 and recipes in the library 40 (these typical profiles and recipes continue to be stored in permanent manner in the memory 500 and are not themselves affected by changes of target).

For each new target, said configuration algorithm thus associates each typical thickness profile with a recipe that represents the most suitable thickness correction specifications for achieving the target when starting from a particular typical profile.

The "most suitable thickness correction specifications" thus cover the specifications which enable a layer to be obtained having a profile thickness that is as similar as possible to the profile represented by the target, assuming that thickness correction is applied in accordance with said thickness correction specifications to a layer that presents a thickness profile corresponding to the typical profile.

This association by means of the configuration algorithm thus takes account not only of the target, but also of the typical profiles and of the recipes.

New associations can thus be stored in the memory 500.

It is specified that it is possible to store a plurality of different configurations in said memory, each configuration possibly assigning a recipe to each typical thickness profile with an association that is different.

Under such circumstances, means are provided to enable a user to select the desired configuration.

It should be observed that the target 30 and the typical profiles in the list 20 are parameters representing similar magnitudes, i.e. a thickness profile described using a determined mesh covering the surface of the thin layer.

In the present specification, the term "thickness profile" is used to mean a series of thickness values for the layer, taken at determined points of the layer.

As mentioned above, these points are distributed in a mesh which is preferably two-dimensional, but could possibly be one-dimensional or even a single point of the surface of the layer. The mesh thus serves as the basis for the following profiles:
· those measured during the operation 1051';
· the typical profiles stored in the list 20; and
· the target profile 30 as stored likewise.

Nevertheless, it should be understood that, in a variant of the invention, provision can be made for all three categories of profile to be stored and used with different levels of detail (for example thickness measurements can be obtained using a very detailed mesh, and used on a target which is defined on a sub-mesh that is less detailed, for example it is typically possible to have a target constituted by a single thickness value for the entire layer).

It is even possible to make provision for the three categories of profile to be defined using meshes that are completely uncorrelated relative to one another: in particular, the mesh defining the measured profile and the mesh defining the correction profile need not be correlated, being defined independently of each other.

In an implementation, these three categories of profile are nevertheless stored and used with the same level of detail in the apparatus for implementing the invention.

It will thus be understood that at any given time, the memory 500 stores the following:
· "permanent" information which can nevertheless be updated:
   ➢ the list 20 of typical profiles; and
   ➢ the library 40 of recipes;
· together with a target 30 and at least one configuration, with only one such configuration being selected at any one time.

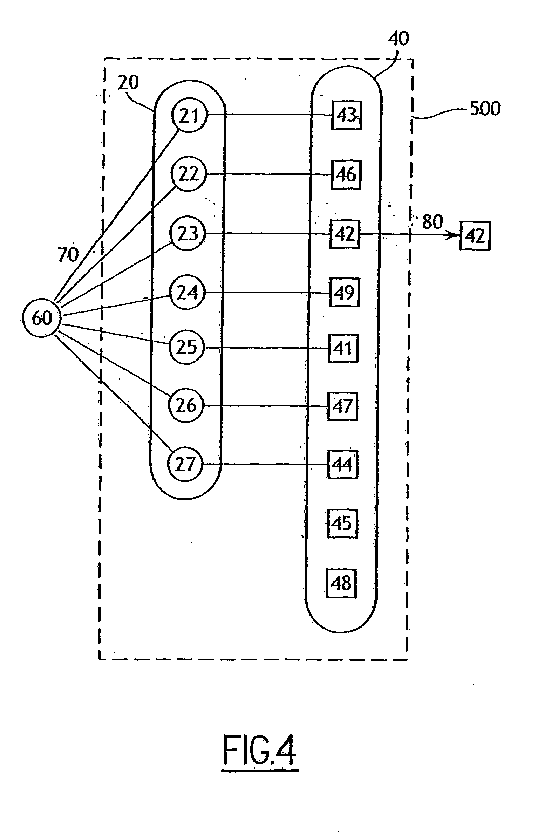

With reference now to Figure 4, there follows a description of how the configuration is used to implement the operation 1052'.

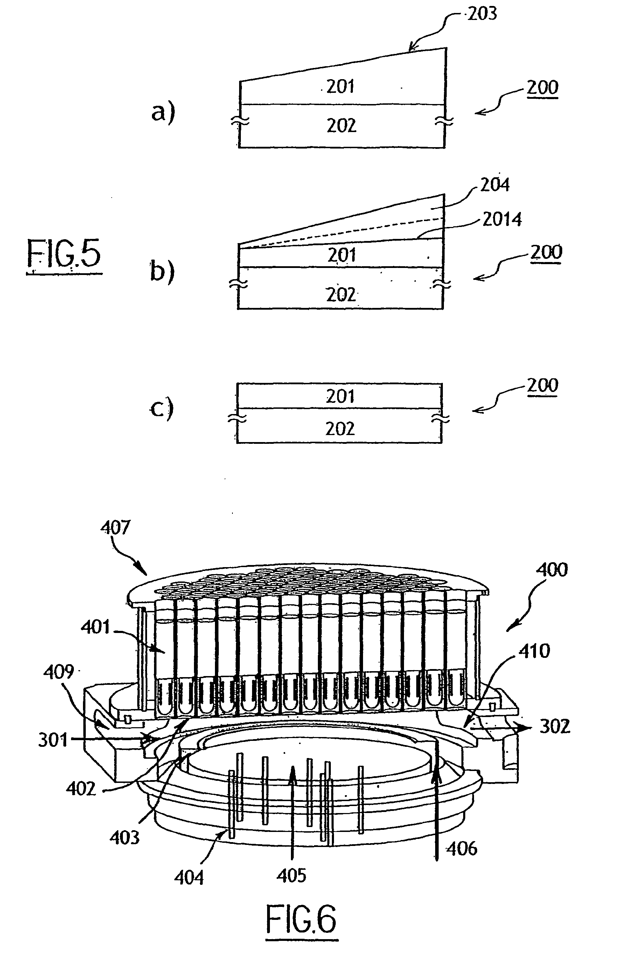

On the basis of a thin layer 201 that is to be finalized (see Figure 5) it is desired to obtain a finished thin layer having a thickness profile that is as similar as possible to the target profile 30 stored in the memory 500, with this being done by applying the thickness correction 1053' using the recipe selected at 1052' following the measurements performed at 1051' on the thickness of the thin layer.

Returning to operation 1052' of deducing the recipe, this operation is performed on two levels.

The first level corresponds to the above-described algorithm, i.e. configuring the apparatus by defining associations between typical profiles and recipes for a given target.

As mentioned above, the configuration algorithm is executed each time there is a change of target (e.g. in order to process a batch of thin layers in some specific manner), in an implementation of the invention that is fully automated.

In any event, even in a fully automated implementation, it is specified that an option can be made available to an operator to update the configuration stored in the apparatus.

In this respect, the operator can establish any desired configuration by defining specific associations between typical thickness profile and recipes in order to load the configuration into the memory of the machine and put into operation.

By way of example, the configuration algorithm may perform the following tasks:
· for each typical profile, evaluating thickness value differences between the typical profile and the target profile 30. These thickness differences then correspond to the thickness corrections that need to be implemented on the typical profile in order to obtain a profile similar to that of the target 30; and
· for each typical profile, deducing the most suitable recipe for implementing the previously-evaluated thickness corrections.

Each typical profile (21 to 27) is then associated with a recipe (41 to 49); in this purely illustrative example, the following associations are deduced: 21 & 43; 22 & 46; 23 & 42; 24 & 49; 25 & 41; 26 & 47; and 27 & 44.

As mentioned above, a user 600 can modify parameters stored in the memory 500, e.g. the target profile 30, the typical profiles (21 to 27), and/or the recipes (41 to 49), and can do this by means of a user/memory interface (such as a keyboard and a screen).

These changes can be constituted by additions, deletions, and/or transformations of parameters.

After such a modification, the user may trigger reconfiguration of the apparatus, i.e. cause the configuration algorithm to be executed, in order to establish new associations.

The second level of the operation 1052', as shown in Figure 4 relates to selecting the recipe (41 to 49) as a function of a stored target 30 and of a measurement profile 60 obtained at 1051' from a thin layer 201.

This second level takes place only once the apparatus has been configured as explained above.

Recipe deduction takes place in two steps:
· a selection step 70 of selecting a typical profile that is the most similar to the measured profile 60 from amongst the typical profiles stored in the list 20. This can be done after evaluating thickness value differences between the measured profile 60 and each of the typical profiles using a given mesh (e.g. the mesh defining the typical profiles, or a sub-mesh of said mesh); and
· deducing at 80 the recipe 41 to 49 which is associated with the typical profiles 21 to 27, by virtue of the associations supplied by the selected configuration (in this respect, it is specified that the processor unit is connected to the various fields of the memory 500).

In this example, the typical profile most similar to the measured profile 60 is referenced 23, and the associated recipe is thus the recipe referenced 42.

The recipe 42 that is deduced in this way comprises parameters suitable for controlling thickness correction in a manner that corresponds to the measured profile 60.

In order to obtain as close as possible a fit for the thicknesses that are obtained by applying the selected recipes, it is possible to increase the number of typical profiles in the list 20 and the number of recipes in the list 40.

In this perspective, it is also possible to adapt the lists of typical profiles and of recipes that are used for selecting the recipe based on thickness measurements, e.g. for certain batches of thin layers.

In a variant implementation of the invention, the lists 20 and/or 40 of typical profiles and of recipes are thus classified in a particular manner, e.g. in a tree structure defining categories and sub-categories (with some desired number of levels).

Under such circumstances, it is possible to group together typical profiles in categories of similar profiles, for example, by using a tree structure of categories, sub-categories, etc. in which the leaves (deepest levels) are constituted by lists 20 of typical profiles.

For example, it is possible to define a category on the basis of very general characteristics of a typical profile, and to make use of characteristics that are more and more detailed when defining groups at deeper levels within the tree structure.

Under such circumstances, and still using the interface of the apparatus, it is possible to select zones of the tree structure of typical profiles in which to search in order to make the selection 70.

This makes it possible to avoid trying to compare layers in a certain batch with typical profiles that do not have the same general characteristics, and to search only amongst categories containing typical profiles similar to the profiles expected of the measured layers.

Under such circumstances, selection 70 is performed in as many steps as the tree structure has levels, an initial selection step serving to select a high level category in the tree structure, with each following step serving to select a sub-category, a sub-sub-category, etc.... each time going down one level of the tree structure until the appropriate list of typical profiles is selected, and finally the most suitable typical profile.

In any event, a single configuration is selected for each list of typical profiles that might need to be searched for selecting a typical profile; once the typical profile has been selected, it is the configuration of the list that contains the typical profile that is used for deducing a recipe.

This selection in successive steps makes it possible to classify the measured profile 60 in successive categories that are of increasing detail and accuracy, in terms of thickness specification.

This provides the advantage of increasing effectiveness and speed during the step of determining which stored typical profile is the most similar to the measured profile 60.

Other variants can also exist and relate to the operation 1052' functioning in the same manner, not at the second level, but at the first level.

It is thus possible to subdivide all of the typical profiles into a plurality of lists 20 ordered in a typical profile tree structure and/or to order all of the recipes in a plurality of lists 40 likewise organized in a recipe tree structure in order to implement the configuration algorithm.

Under such circumstances, in order to establish a configuration, the configuration algorithm that searches for a recipe to be associated with a typical profile does not search through all of the recipes, but begins by selecting categories of recipes as a function of the thickness differences between the target and the typical profile (i.e. by selecting a category of recipes that corresponds best to said differences).

In this case also, the tree structure of recipes is defined by levels of increasingly fine detail on going deeper into the tree structure (i.e. for example, by defining high level categories using few thickness correction parameters and terminating at the bottom of the tree structure with a more complete definition for the recipe).

It is also possible for configuration purposes to establish a link between a given level of a tree structure of typical profiles ("starting level") and a level in the recipe tree structure ("arrival level"): under such circumstances, for each typical profile associated with a given category of the starting level, there exists a recipe arrival level category.

During configuration, any search for a recipe for a typical profile of said starting level is directed automatically towards said arrival level category (searching then continuing down the tree structure of recipes).

It is also possible during configuration to associate a list 20 of typical profiles with the same recipe, or with the same list 40 of recipes, or more generally with the same group of recipes at some particular level of the recipe tree structure.

The same can be done for any list 20 of typical profiles, or more generally for any group at some particular level in the tree structure of typical profiles.

It is also possible to define a tree structure of recipes not in terms of successive levels of detail, but in terms of recipe parameters.

Thus, for example, it is possible to define:
· a first top level category in the tree structure of recipes, with the recipes in this first top level category defining a thickness correction specification that is uniform over the entire surface of the layer; and
· other high level categories depending on overall parameters of the distribution of thickness correction specifications over the surface. For example:
   ➢ greater (or on the contrary smaller) thickness reduction in a central region of the layer;
   ➢ greater (or on the contrary smaller) reduction of thickness in a given angular sector of the layer;
   ➢ etc.

Thus, while selecting the recipe to be applied to a layer whose thickness has been measured, it is possible to navigate in the tree structure of recipes as a function of the main characteristics of the thickness map as measured for the layer.

For example, when a layer has a concave thickness profile, the system will automatically associate a profile thickness profile that is concave corresponding to the measured layer. Continuing this example, if the thickness target is a "flat" target, i.e. corresponding to constant thickness over the entire layer, it is then appropriate to apply a recipe for correcting the observed concave shape.

Under such circumstances, the configuration algorithm makes it possible to select a recipe from the library which searches for a high level category corresponding to "convex" or "bulging" recipes.

The above-mentioned example thus corresponds to thickness correction seeking to obtain uniform thickness within a layer.

The above-mentioned considerations relating to establishing links between typical profiles and recipes remain applicable, regardless of the tree structure implemented.

In all circumstances, the two above-described levels, configuration and selecting a recipe for each measured layer, correspond to operation 1052'.

In a preferred implementation, the operation 1052' of deducing a recipe is performed by apparatus that has electronic components suitable for storing and executing at least one logic program, itself suitable for implementing at least a portion of the deduction operation; by way of example, this can be done by executing binary programs on a computer.

It is specified that the operation 1052' of deducing thickness correction specifications may also be implemented in manners other than the preferred manner described above.

Thus, it is possible to implement any means for preparing correction specifications starting from a stored target and an acquired measurement profile.

In a particularly simple implementation, it is thus possible for each thin layer whose thickness has been measured to cause specifications to be calculated as deduced directly from the thickness differences between the target profile and the measured profile.

In a simplified implementation of the invention, and as mentioned above, it is also possible for thickness correction specifications to be deduced merely by an operator, as a function of the observed thickness measurements.

It is reminded that such simplified implementation does not follow the provision of the second main aspect of the invention.

Under such circumstances, after the operator has deduced the thickness correction specifications that need to be applied a layer that has just been measured, the operator informs the thickness correction means of said specifications.

Still as mentioned above, it is also possible for the operator to provide information concerning thickness correction specifications only in the event of a change of target, assuming that the layers in a given batch, or even the layers in a plurality of consecutive batches, have previously been subjected to fabrication steps under similar conditions and are required at the end of the process to comply with the same thickness target (for example a target constituted merely by an average thickness value, which implies that thickness should be as constant as possible over the layer).

### Thickness correction

The operation 1053' comprises at least one operation of correcting the thickness of the layer in accordance with the thickness correction specifications as previously deduced in 1052'.

The example described in detail below concerning the thickness correction technique relates to a technique of correcting thickness by sacrificial oxidation, which corresponds to a preferred embodiment.

Nevertheless, it is possible in the invention to implement other types of technique for correcting layer thicknesses.

Thus, for example, it is possible to implement techniques of the following type:
. Specific treatment of the surface of the wafers, adapted locally to treat differently the different regions of the wafer surface. Such treatment shall be associated with an annealing step. Such treatment can include a selective heating by individually controlled heat sources such as infrared lamps. This can be done in particular for sacrificial oxidation.
In any case, such locally adapted treatment corrects the thickness of the layer which is treated (and not merely smoothes its surface) with the ability to correct thickness in different manner locally depending on location on the surface of the layer, while allowing to treat simultaneously the entire surface of the layer.

Thus, in an example which corresponds to a particular implementation of the invention, it is possible to treat the thickness of a layer by sacrificial oxidation, by implementing a step of forming an oxide layer on the surface of the layer, optionally an annealing step, and then a deoxidation step.

In the example of a wafer 200 comprising a thin semiconductor layer 201 on a supporting substrate 202 as shown in Figure 5, sacrificial oxidation is implemented to reduce selectively the thickness of the superficial zone 203 at the surface of the layer, where said zone presents too great a lack of uniformity in layer thickness.

The term "selectively" is used to cover the characteristic whereby the oxidation is attacked in differing manner in different regions of the surface of the zone 203.

More precisely, it is specified that "selectively" does not correspond to a "binary" treatment in which certain regions of the layer are either totally oxidized or not oxidized at all.

On the contrary, the idea is to ensure that the amount of oxidation is deliberately varied locally depending on the location on the layer in question.

By implementing a sacrificial oxidation technique, (or another technique as mentioned above) it is possible to vary the modifications in thickness at different locations of the surface of the layer.

A corresponding advantage is that as a result it is possible to treat different regions of a layer selectively in order to apply different thickness corrections to said regions, and to do so in a simultaneous operation.

This advantage constitutes a clear distinction over techniques of the PACE or Epion type mentioned in the introduction of the present application, since those techniques require certain elements of the apparatus to be displaced sequentially (displacement of the layer itself and/or of a mask), in order to obtain such selective thickness correction at different locations on the surface of a layer.

The effect of the sacrificial oxidation technique is shown in Figures 5a to 5c.

Figure 5a thus shows a semiconductor layer 201 (e.g. made of silicon) on a substrate 202.

The layer 201 has a superficial region 203 which defines a thickness that is not uniform (in the simplified example of Figure 5a, the surface of the region 203 presents a slope which is drawn in exaggerated manner).

With reference to Figure 5b, the layer 201 is oxidized by heat treatment so as to form an oxide layer 204. This oxide layer 204 develops in the vicinity of the surface of the layer 201 in the zone 203 (whose boundary is represented by dashed lines in Figure 5b).

During the heat treatment, the interface between the oxide and the silicon moves downwards through the silicon, defining a boundary 2014 between the superficial oxide layer and the layer of silicon 201, and the slope of the boundary becomes closer to a direction parallel to the general direction of the interface between the layer 201 and the substrate 202.

More precisely, the position of the boundary 2014 is defined by the local intensity of sacrificial oxidation.

Since this intensity of sacrificial oxidation is controlled locally (as explained in greater detail below), the position of the boundary 2014 is consequently controlled locally at all points in the layer.

For the simplified situation shown in Figure 5b, it can be considered to a first approximation that is boundary has a position that is substantially symmetrical to the position of the surface of the oxide layer being created, relative to the position of the surface of the region 203 (which region has become "absorbed" into the oxide layer 204).

In a variant which corresponds to the teaching of French patent No. FR 2 777 115 (see in particular example 2), an additional step of annealing the substrate is added to enable the layer 201 to be cured of surface irregularities generated during oxidation and during the preceding steps in the method of preparing the thin layer.

As explained in that patent FR 2 777 115 (see page 11 line 30 to the end of the description), it is possible in particular to treat structure of the SOI type.

With reference to Figure 5c, a deoxidation step follows the annealing.

During this step, the oxide layer 204 is generally consumed chemically. By way of example, in order to remove a thickness of SiO₂ of the order of 50 Å to 200 Å, the wafer 200 is dipped in a bath of 10% or 20% hydrofluoric acid for about 5 s to 30 s.

In the end, a thin layer 201 is obtained (Figure 5c), of thickness that is more uniform (and smaller) than the thickness of the initial thin layer 201 of Figure 5a.

The above-described sacrificial oxidation method is merely a variant of the methods described in document FR 2 777 115; the present invention is not limited to this particular variant and extends to all other sacrificial oxidation methods.

The main parameters of oxidation heat treatment techniques are temperature, duration of oxidation, and the partial pressure of oxygen in the oxidation atmosphere.

These parameters can be well controlled, thus giving good reproducibility to this application of the method.

The method is also flexible in use and compatible with all of the usual procedures for treating thin layers or wafers in the fabrication of microelectronic components.

Figures 6 to 10 show a particular treatment of the thin layer by sacrificial oxidation using an RTO technique.

The apparatus for treating thin layers by sacrificial oxidation on which the description below is based is an RTP XE Centura apparatus from the supplier Applied Materials^{®}.

That apparatus comprises in particular an oxidation chamber 400 suitable for containing at least one semiconductor thin layer or wafer carrying a semiconductor thin layer.

The thin layer or the wafer is supported inside the oxidation chamber on a flat annular turntable 403, which is generally made of silicon carbide.

A heating system is located above the thin layer, the heating system comprising a plurality of lamps 401, each generally being placed inside a lightweight tube.

The lamps 401 are preferably of the halogen type.

The lamps 401 are advantageously disposed in such a manner as to cover the entire surface of the thin layer.

Because of the large amount of heat given off by the heating system (about 1000°C), it is recommended to install a cooling circuit 407 in the wall of the oxidation chamber 400 in order to remove the heat and thus avoid possible burning of the outside walls of the chamber 400.

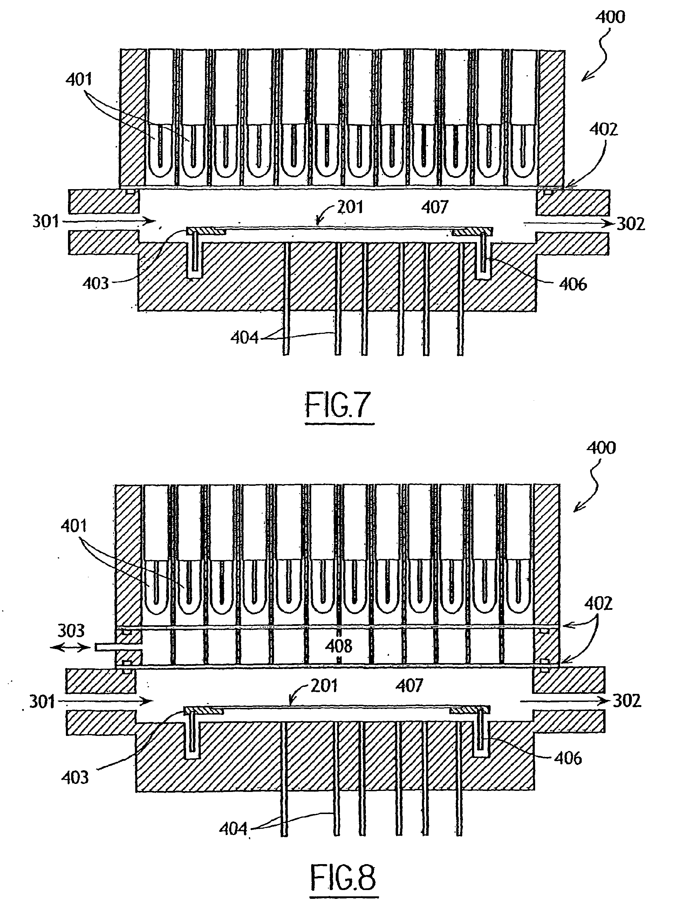

A fine window 402, generally made of quartz, separates the chamber lamps 401 from the oxidizing gas 407, the gas chamber 407 being an empty space situated above the thin layer (see Figure 7 and Figure 8).

At least two openings 409 and 410, generally facing openings, are formed through the wall of the oxidation chamber 400 leading to the gas chamber 407, each opening being suitable for being connected hermetically to a pumping system so as to enable oxidizing gas to enter 301 and leave 302 the gas chamber 407.

A cylinder 406, which is preferably hollow and preferably made of quartz, is situated beneath the support 403 and secured thereto, and is suitable for imparting rotation about the axis of the cylinder relative to the oxidation chamber 400.

The cylinder 406 thus enables the thin layer to be turned beneath the lamps 401, so as to obtain heat treatment that is as uniform as possible, being applied to the entire layer and overcoming any effects of heating that is non-uniform locally.

This is particularly advantageous when it is desired to apply a uniform recipe over the entire surface of the layer.

In general, the configuration with a support 403 that can be set into rotation is well adapted to situations in which thickness is to be corrected symmetrically about the axis of rotation of the support.

This can be desirable in particular when treating batches of layers that have previously been subjected to preparation and treatment steps that themselves have the effect of modifying the properties of the layer in a manner that is symmetrical.

Nevertheless, in a variant, it is also possible to use a support 403 that is stationary.

A temperature measuring system is also installed in the chamber, generally being placed beneath the thin layer and/or the wafer.

The temperature measuring system preferably comprises a reflecting tray 405 suitable for amplifying the thermal radiation information so that sensors 404 can pick up the temperature information and transmit it to a control unit connected to the processor unit.

The sensors 404 are placed so as to measure the temperature profile of the oxidizing gas in the vicinity of the surface of the thin layer.

The sensors 404 are preferably optical fibers, and they are thus designed to transmit optical information in the form of heat rays taken from close to the reflecting tray 405 to a control unit.

With reference to Figure 7, the gas inlet at 301 spends a predetermined duration in the gas chamber 407 where it is raised to a reference temperature. Gas outlet takes place via 302.

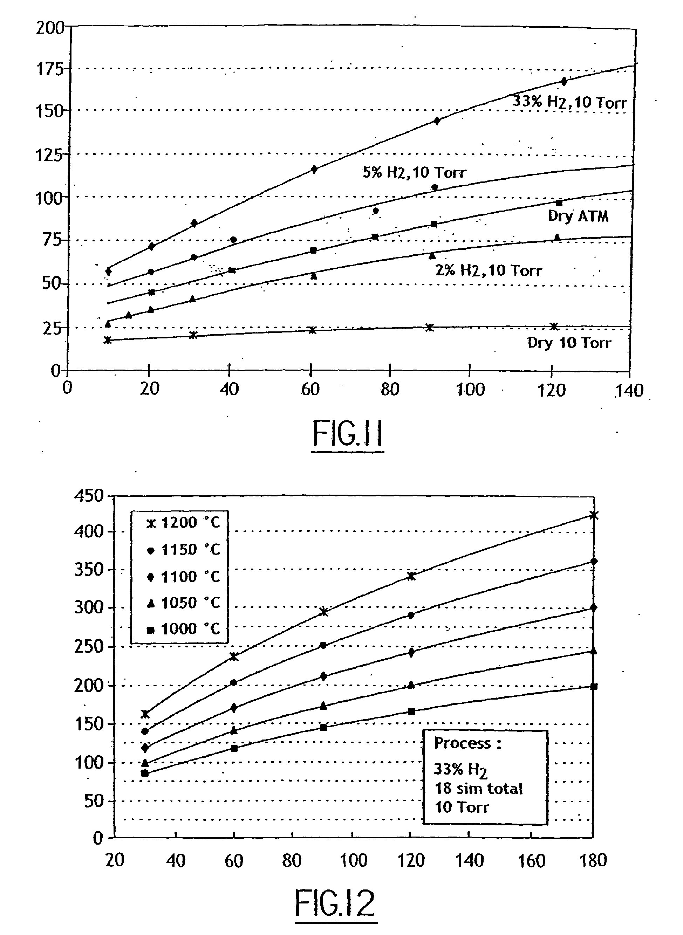

As mentioned above, once the nature of the gas, the oxygen concentration in the atmosphere, and the pressure have been set, it is the parameters of duration and temperature that act in real time to determine the mean thickness of oxide formed in a thin layer 201, as shown in Figure 12.

This figure plots increasing thickness (up the ordinate axis) of thin layers for different durations of oxidation (along the abscissa axis), and it does so for different oxidation temperatures which correspond to the different curves.

The higher the oxidation temperature, the greater the mean thickness of the oxide layer, for given oxidation duration set at a particular value.

The longer the duration of oxidation, the greater the mean thickness of the oxide layer, for given temperature fixed at a certain value.

Temperature is also controlled regulating the power supply to the lamps 401 individually (or in groups).

Individualized electrical power supply adjustment to each lamp thus makes it possible to establish a temperature profile that differs and that is predetermined over the entire surface of the thin layer.

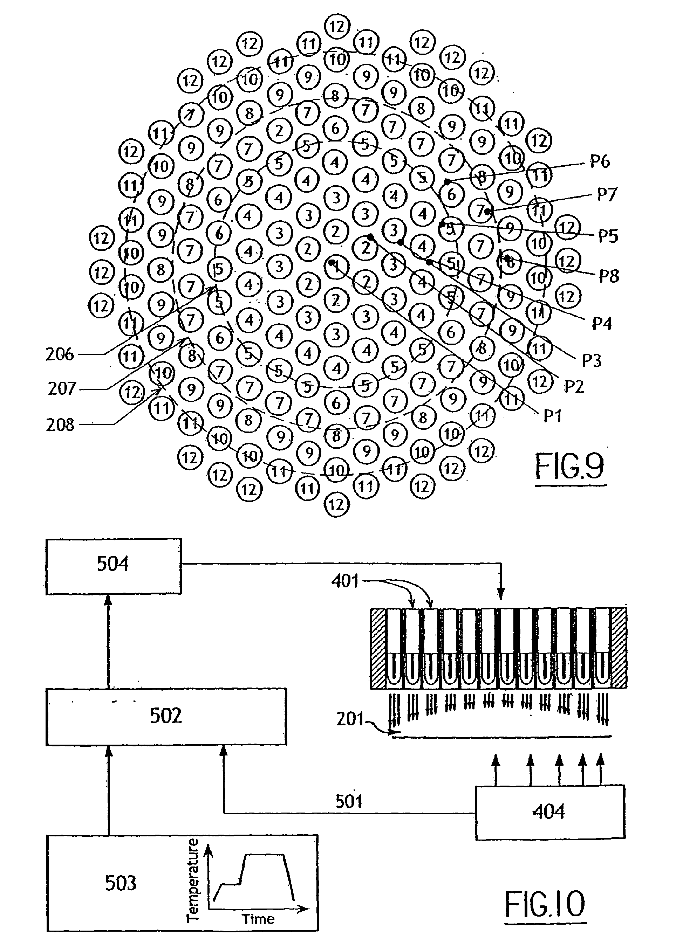

This is shown in Figure 9 for three types of thin layer size referenced 206, 207, and 208, each type being in the form of a disk.

In the particular example shown, the lamps are organized in twelve categories numbered 1 to 12 going from lamps overlying the central zone towards lamps overlying the peripheral zones of the layers 206, 207, and 208. In this example, each lamp number corresponds to a lamp temperature.

It is specified that the number of lamp categories can be adapted as a function of needs: the number can be increased if it is desired to distinguish the thickness correction applied to different locations of the layer more finely.

The temperature obtained at a point on the surface of the layer depends firstly on the lamp which is closest thereto, but also on adjacent lamps, so the central zone of the layer will be hotter than its peripheral zone in the event of all of the lamps being powered uniformly (i.e. if all lamp numbers are the same).

If uniform temperature (and thus uniform oxidation) is desired over the entire surface of the layer 206, 207, or 208, then the central lamps are powered in such a manner as to cause them to be at a lower temperature than the peripheral lamps.

In contrast, if it is desired to obtain temperature differences (and thus oxidation difference) over the surface of the layer 206, 207, or 208, it suffices to adapt the power supply to each lamp in such a manner as to obtain the desired temperature profile.

The amount of power delivered selectively to each lamp stems directly from the commands that correspond to the selected recipe, which commands are forwarded to the thickness correction apparatus by the processor unit.

It is also specified that the thickness correction apparatus can be calibrated in such a manner that the recipes (as prepared automatically by the processor unit or merely by an operator) whose characteristics are forwarded in the form of commands to the thickness correction apparatus, do actually produce the desired effect in terms of thickness correction.

Such calibration can be implemented by observing the reference effects of thickness correction (recipes) on the surfaces of layers. The thickness correction operation can even be followed by a final step of measuring layer thickness in order to detect any drift in thickness correction relative to the specified recipe.

Under such circumstances, it is possible to provide a regulation loop for the thickness correction apparatus in order to adapt the power supply of different categories of lamp so as to remedy any such drift almost in real time.

It is also specified that the main parameters characterizing sacrificial oxidation can be tracked and taken into account by the processor unit controlling the correction apparatus.

For these purposes, the processor unit is connected to various sensors serving to characterize how sacrificial oxidation operations are running (in particular time and various temperature probes).

Temperature adjustment operations can be facilitated by making temperature measurements using sensors 404, which are given references P1, P2, P3, P4, P5, P6, P7, and P8 that are located in the vicinity of the layer.

The duration of sacrificial oxidation is also defined in the commands forwarded by the processor unit to the thickness correction apparatus once a recipe has been selected.

This duration of oxidation is determined in particular by means of reference values preestablished from a list of previously-made measurements stored in the processor unit.

These previously-made measurements comprise the following:
· known machine sequence duration measurements (for example the time duration between the gas inlet time 301 and the gas outlet time 302, or the duration between the time the thin layer enters the oxidation chamber and the time it leaves it, or indeed the duration between the time when heating is started and the time when it ends, etc.); and
· oxide thickness measurements for a certain number of layers that are post-oxidized under predetermined oxidation conditions.

On the basis of comparisons of those two types of measurement, and on the basis of the selected recipe, the processor unit deduces reference values for determining the duration of oxidation for layers prepared under the same predetermined oxidation conditions.

It should be added that the main parameters influencing oxidation duration (control of the chemical composition of the oxidizing gas during oxidation, temperature control, pressure control, etc.) are themselves likewise controlled.

In this respect, a variant of the apparatus shown in Figure 8 shows additional means for controlling gas pressure in the chamber 407.

The diagram of Figure 8 shows an oxidation chamber 400 including an additional pressurizing chamber 408 connected to at least one vacuum pump and enabling reduced pressure to be established inside the gas chamber 407.

For reduced pressures, this enables layer oxidation speed to be influenced, and thus makes it possible to achieve better control over layer thickness.

The pressures used are typically greater than a few torr, and thus values greater than 0.01 atmospheres.

The vacuums thus used are much softer than those required by prior procedures seeking to achieve the same objects as for the present invention. This softer vacuum correspondingly reduces constraints on the means needed to implement the method (pumping means, sealing means, monitoring means).

Nevertheless, thermal oxidation can also be implemented under atmospheric pressure, or even at higher pressure.

Concerning the chemical composition parameter of the oxidizing gas, it is the usual practice prior to admitting any gas 301 to have an atmosphere that has been made as inert as possible and as non-oxidizing as possible, e.g. using an inert gas or hydrogen.

A surface oxide layer can generally be formed by a dry technique or by a wet technique.

In the dry technique, the surface oxide layer is formed under gaseous oxygen.

In the wet technique, the surface oxide layer is formed by using steam.

For the wet technique, a preferred technique relates to an inlet gas mixture 301 including O₂ and hydrogen.

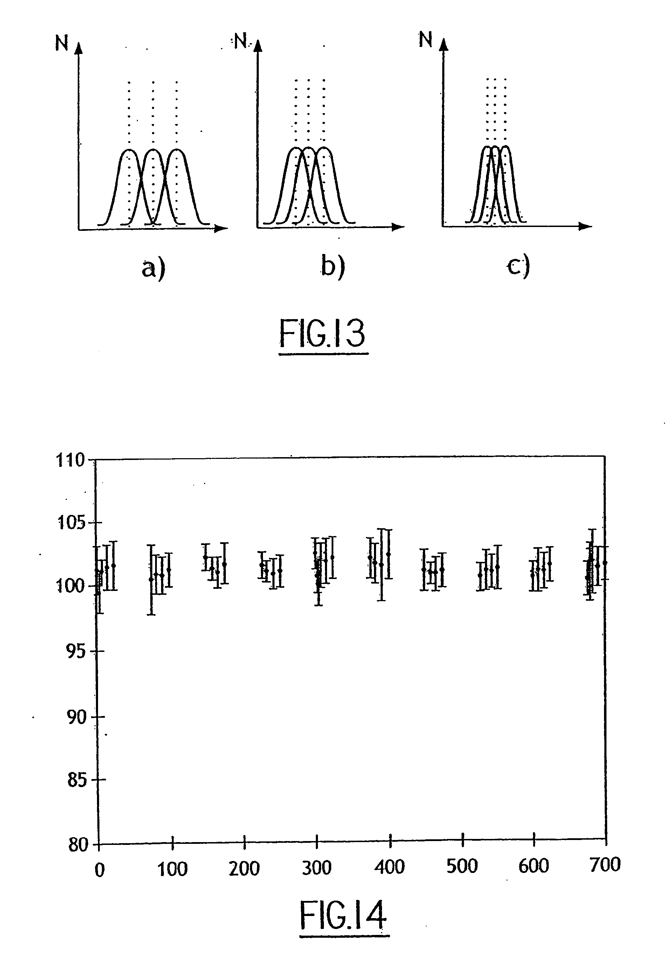

In practice, all of these parameters (temperature, duration, pressure, gas composition) are controlled thus making it possible to achieve reliable reproducibility of oxidation for variations in oxide thickness that can oscillate around 10 Å, as shown for example by Figure 14 in which oxide thickness is plotted up the ordinate axis and is compared for 700 layers (plotted along the abscissa axis) prepared under the same preparation conditions.

These parameters are also easy to adjust, making such a method much more flexible in use and much more uniform than the usual set of procedures implemented for treating thin layers and/or wafers when fabricating microelectronic components.

Figure 10 shows a method of operating a rapid thermal oxidation chamber.

It is specified that in the most complete version of the apparatus of the invention (including in particular a processor unit), the hardware means mentioned for said rapid thermal oxidation are connected to the processor unit and are controlled thereby.

A thickness control unit 502 adjusts a preestablished time/temperature profile 503 as a function of temperature measurements 501 received from sensors 404 level with a thin layer 201, and it powers the lamps 401 to comply with the selected profile 503.

Such apparatus thus provides accurate and easy control over the oxidation process, and thus over the thickness values of the layer 201.

The control unit 502 can also advantageously take account of specifications for gas composition parameters, pressure in the gas chamber, gas admission, rate of throughput of layers inside the chamber, etc.

As a result, implementing sacrificial oxidation whereby a thickness is removed from the layer takes place more quickly than with prior art techniques, given that this sacrificial oxidation technique is performed simultaneously over the entire layer (and is not performed locally).

Variants of such apparatus relate to oxidation chambers suitable for containing a plurality of thin layers, or to associations of a plurality of oxidation chambers for the purpose of further increasing the throughput rate of layers in the facility for preparing them.

The thickness correction apparatus used for implementing the present invention is not restricted to the rapid thermal oxidation apparatus 400 described above, but covers any other thermal oxidation apparatus.

In general, the method of the invention can be implemented by any method using sacrificial oxidation to correct thickness.

In general, the sacrificial oxidation technique achieves correction accuracy that is much better than that which can be envisaged with known techniques.

It is however recalled that sacrificial oxidation only corresponds to a preferred embodiment of the invention, but is not limiting.

Others techniques for selectively correcting the thickness of a layer can be used, as long as such technique allows to simultaneously treat the entire surface of the wafer while locally and selectively adapt wafer thickness in different regions of the wafer surface.

An application of the present method consists in uniform removal of matter from the surface of the layer over a depth which can be as much as several hundreds of angstroms.

This is achieved by selecting a recipe having a single thickness correction value, enabling the thickness of the layer that is to be corrected to be reduced in uniform manner.

Under such circumstances, the oxidation apparatus adjusts the temperature within the oxidation chamber, in particular by acting on the electrical power supply to the lamps 401 and on the duration of oxidation so as to obtain a uniform temperature over the entire surface of the layer, and thus obtain uniform oxidation.

Another application consists in removing material in a manner that differs selectively over the surface of the layer, for example in order to adjust uniformity within a layer.

In the particular circumstance where an attempt is thus made to achieve uniform thickness throughout the layer, it can be necessary to compensate for certain uneven zones, such as convex or concave cylindrical symmetry that appears during layer preparation, or slopes going to "left" or to "right", etc.

Such differential removal of material can be implemented by a sacrificial oxidation method, in particular by locally establishing a specific oxidation temperature over the surface of the layer, and thus establishing specific local oxide thicknesses, by selecting an appropriate recipe which causes corresponding commands to be delivered to the sacrificial oxidation apparatus.

Returning to the case of the oxidation chamber 400, such a command will cause the lamps 401 to be powered selectively in such a manner as to achieve the desired corrections in the selected zones.

The term "selective power supply" for the lamps 401 does not mean binary (on/off) power supply, but means power supply that can be varied continuously and progressively between different levels of power supply so as to adapt the power to each lamp individually.

It is also possible to combine recipes when treating a single layer.

Thus, in particular, it is possible to implement a correction (e.g. a large correction) of thickness in uniform manner over the layer, and then to implement a finer differential correction for compensating for local non-uniformities of thickness, such local compensation being implemented by differential sacrificial oxidation.

By this method of preparing a layer that includes thickness correction operations, the treatment of the layer by sacrificial oxidation is adapted to present thicknesses of thin layers.

The oxidation temperature and time parameters are easily adjustable and can define the quantity of material to be removed, thus making it possible to control the technique in such a manner as to obtain a quantity of removed material that can vary in controlled manner over the range a few tens of angstroms to a few thousands of angstroms, without that leading to significant crystal defects, thereby leading to applications on layers that are very thin.

In practice, these points make it possible to apply the method of the present invention to semiconductor thin layers having a mean thickness well below 1 µm.

Another aspect of the invention lies in the fact that thin layers are generally prepared in batches.

In this aspect of the invention, a single target thickness profile is defined for all of the layers in a batch (i.e. the "target" 30 is common to all of the layers in the batch).

The respective thickness correction specifications for each layer in the batch are then individualized in such a manner that each layer of the batch, after thickness correction has been performed, presents a final layer thickness profile that is as close as possible to the target profile.

The thickness corrections may be uniform, differential, or both uniform and differential, as described above.

The method as applied to batches of layers can also be applied to a batch organized as a succession of layers, in which the mean thickness of one layer in the batch is measured (1051') while the thickness of the preceding layer in the same batch is being corrected (1053'), after the thickness of said preceding layer has itself been measured.

An overall result of using a method of this type in accordance with the invention is shown in Figure 13 which comprises three graphs 13a, 13b, and 13c.

These three graphs represent histograms of thickness distribution amongst layers in a given batch (for simplification purposes, each batch is shown comprising three layers).

Each histogram curve thus corresponds to a single layer, representing the number N of points on the surface of the layer that had a given thickness (thickness plotted along the abscissa axis, N up the ordinate axis).

Each layer thus has a thickness which can typically be represented by a Gaussian curve (with the points at which thickness is determined being defined by a mesh over the surface of the layer).

Vertical dotted lines represent the mean thickness of each layer.

Graph 13a thus shows a first distribution of thicknesses for the three layers in a batch. Each of these three layers presents a distribution of thicknesses about a respective mean thickness.

Graph 13b shows the same layers after treatment by sacrificial oxidation seeking to make the mean thicknesses of the layers uniform.

For this purpose, a configuration was adopted in which the recipes selected for each layer were individualized, as a function of the measurements of the layer, and for the purposes of achieving a common target.

This leads to the mean thicknesses of the layers in the batch coming closer together (better layer-to-layer or wafer-to-wafer uniformity).

It is also possible to consider that, a priori, the layers in each batch present similar thickness profiles, within given tolerances. This is true in particular when the layers in a given batch have previously been subjected to the same fabrication steps under the same conditions.

Under such circumstances, it is possible to measure only some of the layers in the batch (or even only one layer), instead of measuring all of the layers of the batch. Depending on the result of this or these thickness measurement(s), a single recipe is deduced (automatically, or by an operator) for application to all of the layers in the batch for the purpose of correcting thickness.

Such treatment, the result of which is not shown in the figures, leads to a shift in the mean thickness values of the layers in the batch, without said values coming closer together (the shift is towards smaller values of mean thickness, because of the way thickness is corrected).

Finally, the particular thickness correction apparatus described above (of the RTP XE Centura^{™}) merely constitutes a non-limiting example which is particularly well suited to correcting the thickness of a single layer at a time.

It is possible to implement the method of the invention using any apparatus for correcting the surface thickness of a layer.

In particular, such apparatus can make it possible advantageously to correct layer thickness in selective manner.

It is recalled that the term "selective" is used herein to cover the ability to attack different regions of the surface of the layer in differential manner.

By correcting the thickness of each layer in selective and individualized manner (which means that each layer whose thickness is to be corrected must be measured), it is possible to narrow the spread of the thickness distribution histogram for each layer of the batch, and also to move the mean thickness values of the layers closer together.

This is shown by the graph 13c.

In all circumstances, thickness correction implements sacrificial oxidation.

It is thus possible, for example, to process entire batches of layers in horizontal or vertical tube ovens (where vertical tube ovens are also referred to as "bells)".

Such annealing ovens are known in the state of the art. They enable entire batches of layers to be subjected to heat treatment. The layers are aligned one after another, e.g. in quartz boats provided with parallel notches for receiving the layers.

It is possible to adjust the characteristics of the heat treatment applied by the oven so as to apply selective thickness correction to the surface of each layer of the batch in different regions of the layer.

For this purpose, action can be taken in particular on the composition of the mixture of gases inside the oven, and more precisely on the composition of the mixture of gases circulating in the various portions of the oven.

It is possible to provide that the mixture is more or less oxidizing in certain regions of the oven. This can be achieved by local flow of a specific gas mixture.

Thus, when it is desired to treat all of the layers in a batch in the same manner, all of the dispositions seeking to produce special conditions locally inside the oven are applied in the same manner to all of the layers in the batch.

It is also possible to act on the presence of hot zones inside the oven.

In this case also, the presence of hot zones can be defined so as to have the same influence on all of the layers in a batch.

For example, provision can be made to ensure that the sacrificial oxidation attacks the layers more in their peripheral regions than in their central regions, which corresponds to a convex recipe.

It is possible to act on the flows of gas inside the oven, in order to obtain such hot zones.

In contrast, it is also possible to manage non-uniformities of temperature inside the oven in controlled manner so as to cause the heat treatment applied to the various layers in a batch to be different.

## Claims

1. A method of preparing a thin layer (201) of semiconductor material, the method including a step (1050') of correcting the thickness of the layer, said step of correcting thickness of the layer (201) itself comprising the following operations:
- acquiring (1051') a measured thickness profile (60) of the layer;
- deducing (1052') thickness correction specifications (40) from the measured thickness profile (60); and
- correcting (1053') the thickness of the layer in accordance with said specifications;
the method being **characterized in that** thickness correction (1053') implements a technique which simultaneously treats the entire surface of the layer, while locally and selectively adapt layer thickness in different regions of the layer surface, said technique implementing sacrificial oxidation.

2. A method according to the preceding claim, **characterized in that** the thickness correction specifications (40) correspond to uniform thickness correction (1053') over the surface of the layer (201) to be prepared.

3. A method according to claim 1 or 2, **characterized in that** thickness correction specifications (40) correspond to differential thickness correction (1053') over the surface of the layer (201) to be prepared.

4. A method according to any preceding claims, **characterized in that** the thickness correction specifications (40) correspond to uniform thickness correction (1053') over the surface of the layer to be prepared in combination with differential thickness correction (1053') over the surface of the layer (201) to be prepared.

5. A method according to any preceding claims, **characterized in that** the thickness correction specifications (40) are established in such a manner as to produce a layer (201) with a minimum variation of its thickness over the entire layer (201).

6. A method according to any preceding claims, **characterized in that** layers are prepared in batches of layers.

7. A method according to any preceding claims, **characterized in that** layer thickness correction is performed on batches of layers.

8. A method according to either one of the two preceding claims, **characterized in that** the layers of a batch are organized in a succession of layers, with the thickness of one layer in the batch being measured (1051') while the thickness of a preceding layer in the same batch is being corrected (1053').

9. A method according to claim 6 or claim 7, **characterized in that** for all of the layers of the batch, a single target thickness profile (30) is defined, and the respective thickness correction specifications (40) for each of the layers of the batch are individualized in such a manner that, once thickness correction has been performed, each layer of the batch has a final layer thickness profile that is close to the target thickness profile (30).

10. A method according to any one of claims 6 to 8, **characterized in that** for all of the layers of the batch, a single target thickness profile is defined, and the thickness correction specifications of all of the layers of the batch are the same, as a function of at least one thickness measurement performed on a layer of the batch.

11. A method according to either one of the two preceding claims, **characterized in that** the target thickness profile (30) consists in a target value, said target value designating a single target thickness to be achieved over the entire surface of each of the layers of the batch.

12. A method according to any preceding claims, **characterized in that** the operation (1051') of acquiring a measurement is performed by an ellipsometer.

13. A method according to any one of claims 1 to 11, **characterized in that** the operation (1051') of acquiring a measurement is performed by a reflectometer.

14. A method according to any preceding claims, **characterized in that** the sacrificial oxidation is implemented by a thermal oxidation technique.

15. A method according to the preceding claim, **characterized in that** the sacrificial oxidation is implemented by a rapid thermal oxidation technique.

16. A method according to any preceding claims, **characterized in that** during sacrificial oxidation, means are implemented for selectively oxidizing different locations of the layer.

17. A method according to the preceding claim, **characterized in that** during sacrificial oxidation, apparatus is implemented including a plurality of heater lamps situated facing different locations of the layer and capable of being powered selectively so as to adjust locally the temperature at which the layer is oxidized.

18. A method according to any preceding claims, **characterized in that** it also implements the steps of a layer transfer technique.

19. A method according to any preceding claims, wherein deducing (1052') thickness correction specifications
- establishing a thickness profile of the layer on the basis of the acquired thickness measurements;
- comparing said profile with stored typical profiles, each typical profile being stored in association with respective thickness correction specifications or recipes; and
- selecting a stored typical profile in order to associate a layer whose thickness is to be corrected with the thickness correction specifications that are stored in association with the selected typical profile.

20. A method according to the preceding claim, **characterized in that** the method includes a configuration step enabling associations to be established between the stored typical profiles and the recipes.

21. A method according to the preceding claim, **characterized in that** said configuration is implemented by an algorithm having, as an item of input data, a target specification for thickness profile established for layer fabrication.

22. A method according to the preceding claim, **characterized in that** the thickness measurements, the typical profiles, and the target are defined using identical meshes.

23. A method according to either one of the two preceding claims, **characterized in that** on each change of target, the configuration algorithm is automatically reactivated to establish a new configuration defining correspondences between the typical profiles and the recipes.

24. A method according to any one of the four preceding claims, **characterized in that** the method includes storing at least one configuration.

25. A method according to any of the six preceding claims, **characterized in that** the method includes storing a plurality of configurations, and selecting a desired configuration.

26. A method according to any of the seven preceding claims, **characterized in that** the typical profiles and/or the recipes are classified in a tree structure defining categories and sub-categories with a desired number of levels.

27. A method according to the preceding claim, **characterized in that** zones of the typical profile tree structure can be selected within which to undertake a search in order to select a typical profile.

28. A method according to either one of the two preceding claims, **characterized in that** the recipe tree structure is defined by finer and finer levels of detail going deeper into the tree structure.

29. A method according to the preceding claim taken in combination with claim 21, **characterized in that** in order to establish a configuration, the configuration algorithm searching for a recipe to associate with a typical profile does not search through all of the recipes, but begins by selecting categories of recipes as a function of thickness differences between the target and the typical profile.

30. A method according to any one of the four preceding claims taken in combination with claim 21, **characterized in that** for configuration purposes, a link is established between a given starting level of a typical profile tree structure
and a given arrival level of a recipe tree structure, such that for each typical profile belonging to a given category of starting level, there exists an arrival level category of recipes, and during configuration, all searching for a recipe for a typical profile at this starting level is automatically directed towards said arrival level category, searching then continuing by going deeper into the recipe tree structure.

31. A method according to either one of the two preceding claims, **characterized in that** the recipe tree structure is defined by recipe parameters.

32. A method according to the preceding claim, **characterized in that** the high level categories of recipes in the recipe tree structure comprise:
- a first high level recipe category defining a uniform thickness correction specification for the entire surface of the layer; and
- other high level categories depending on overall distribution parameters for thickness correction specifications over said surface.

33. A method according to any of the fourteen preceding claims, **characterized in that** the thickness correction is applied simultaneously to the entire surface of a layer, with it being possible to cause said correction to differ depending on location on the surface of the layer.

34. A method according to any of the fifteen preceding claims, **characterized in that** layers are treated in batches, the thickness of one layer in a batch being measured while correcting the thickness of a layer in said batch preceding said measured layer by a given pitch.

35. A method according to the preceding claim, **characterized in that** the layers in a given batch share the same final target thickness, and the recipe for each layer is individualized in such a manner as to ensure that once thickness correction has been performed, a mean layer thickness is obtained for the batch that is as close as possible to the common target.

36. A method according to any of the seventeen preceding claims, **characterized in that** the recipes correspond to thickness modification that is uniform over the entire layer.

37. A method according to any of the eighteen preceding claims, **characterized in that** the recipes correspond to differential thickness modification over the surface of the layer.

38. A use of a method according to any preceding claims to fabricate a layer of semiconductor material in a multilayer structure.

39. A use according to the preceding claim, **characterized in that** said layer is made of silicon.

40. A use according to either one of the two preceding claims, **characterized in that** the multilayer structure is an SOI structure.

41. A machine for implementing a method according to any one of claims 1 to 37, the machine being **characterized in that** it comprises means for acquiring a thickness profile measurement for a layer, and means for correcting layer thickness by sacrificial oxidation, which simultaneously treats the entire surface of the layer, while locally and selectively adapt layer thickness in different regions of the layer surface, in accordance with received thickness correction specifications.

42. A machine according to the preceding claim, **characterized in that** it further comprises a processor unit connected to the measurement acquisition means and to the thickness correction means.

43. A machine according to the preceding claim, **characterized in that** said means for acquiring a thickness profile measurement, said thickness correction means, and said processor unit are integrated in the machine.

44. A machine according to any one of the three preceding claims, **characterized in that** the means for acquiring a thickness measurement implements a reflectometer.

45. A machine according to any one of the four preceding claims, **characterized in that** the thickness correction means are adapted to correct the thickness of a single layer at a time.

46. A machine according to any one of claims 41 to 44, **characterized in that** the thickness correction means enable the thickness of entire batches of layers to be corrected.

47. A machine according to the preceding claim, **characterized in that** the thickness correction means is a tube oven.

48. A machine according to any one of claims 41 to 43, **characterized in that** the means for acquiring a thickness measurement comprise an ellipsometer.

## Patentansprüche

1. Verfahren zum Präparieren einer dünnen Halbleitermaterialschicht (201), wobei das Verfahren einen Schritt (1050') des Korrigierens der Dicke der Schicht umfasst, wobei der Schritt des Korrigierens der Dicke der Schicht (201) selbst die folgenden Vorgänge umfasst:
- Gewinnen (1051') eines gemessenen Dickenprofils (60) der Schicht;
- Ableiten (1052') von Dickenkorrekturspezifikationen (40) aus dem gemessenen Dickenprofil (60); und
- Korrigieren (1053') der Schichtdicke gemäß den Spezifikationen;
wobei das Verfahren **dadurch gekennzeichnet ist, dass** die Dickenkorrektur (1053') eine Technik anwendet, die die gesamte Oberfläche der Schicht gleichzeitig behandelt, während die Schichtdicke in verschiedenen Bereichen der Oberfläche der Schicht lokal und selektiv angepasst wird, wobei die Technik eine Opferoxidation anwendet.

2. Verfahren gemäß dem vorangehenden Anspruch, **dadurch gekennzeichnet, dass** die Dickenkorrekturspezifikationen (40) einer einheitlichen Dickenkorrektur (1053') über die Oberfläche der zu präparierenden Schicht (201) entsprechen.

3. Verfahren nach Anspruch 1 oder 2, **dadurch gekennzeichnet, dass** die Dickenkorrekturspezifikationen (40) einer unterschiedlichen Dickenkorrektur (1053') über die Oberfläche der zu präparierenden Schicht (201) entsprechen.

4. Verfahren nach einem der vorangehenden Ansprüche, **dadurch gekennzeichnet, dass** die Dickenkorrekturspezifikationen (40) einer einheitlichen Dickenkorrektur (1053') über die Oberfläche der zu präparierenden Schicht in Kombination mit einer unterschiedlichen Dickenkorrektur (1053') über die Oberfläche der zu präparierenden Schicht (201) entsprechen.

5. Verfahren nach einem der vorangehenden Ansprüche, **dadurch gekennzeichnet, dass** die Dickenkorrekturspezifikationen (40) derart festgelegt sind, dass sie eine Schicht (201) mit einer minimalen Variation ihrer Dicke über die gesamte Schicht (201) erzeugen.

6. Verfahren nach einem der vorangehenden Ansprüche, **dadurch gekennzeichnet, dass** Schichten in Schichtengruppen präpariert werden.

7. Verfahren nach einem der vorangehenden Ansprüche, **dadurch gekennzeichnet, dass** eine Schichtdickenkorrektur an Schichtengruppen durchgeführt wird.

8. Verfahren nach einem der beiden vorangehenden Ansprüche, **dadurch gekennzeichnet, dass** die Schichten einer Gruppe in einer Folge von Schichten organisiert sind, wobei die Dicke einer Schicht in der Gruppe gemessen wird (1051'), während die Dicke einer vorangehenden Schicht in derselben Gruppe korrigiert wird (1053').

9. Verfahren nach Anspruch 6 oder Anspruch 7, **dadurch gekennzeichnet, dass** für alle der Schichten der Gruppe ein einziges Zieldickenprofil (30) definiert wird, und dass die jeweiligen Dickenkorrekturspezifikationen (40) für jede der Schichten der Gruppe derart individualisiert werden, dass, wenn eine Dickenkorrektur durchgeführt wurde, jede Schicht der Gruppe ein endgültiges Schichtdickenprofil aufweist, das nahe am Zieldickenprofil (30) ist.

10. Verfahren nach einem der Ansprüche 6 bis 8, **dadurch gekennzeichnet, dass** für alle der Schichten der Gruppe ein einzelnes Zieldickenprofil definiert wird, und dass die Dickenkorrekturspezifikationen aller Schichten der Gruppe die gleichen sind, als Funktion wenigstens einer an einer Schicht der Gruppe durchgeführten Dickenmessung.

11. Verfahren nach einem der beiden vorangehenden Ansprüche, **dadurch gekennzeichnet, dass** das Zieldickenprofil (30) aus einem Zielwert besteht, wobei der Zielwert eine einzige Zieldicke angibt, die über die gesamte Oberfläche jeder der Schichten der Gruppe erreicht werden soll.

12. Verfahren nach einem der vorangehenden Ansprüche, **dadurch gekennzeichnet, dass** der Vorgang (1051') des Gewinnens einer Messung durch ein Ellipsometer durchgeführt wird.

13. Verfahren nach einem der Ansprüche 1 bis 11, **dadurch gekennzeichnet, dass** der Vorgang (1051') des Gewinnens einer Messung durch ein Reflektometer durchgeführt wird.

14. Verfahren nach einem der vorangehenden Ansprüche, **dadurch gekennzeichnet, dass** die Opferoxidation durch eine thermische Oxidationstechnik durchgeführt wird.

15. Verfahren gemäß dem vorangehenden Anspruch, **dadurch gekennzeichnet, dass** die Opferoxidation durch eine schnelle thermische Oxidationstechnik durchgeführt wird.

16. Verfahren nach einem der vorangehenden Ansprüche, **dadurch gekennzeichnet, dass** während der Opferoxidation Mittel zum selektiven Oxidieren verschiedener Stellen der Schicht angewendet werden.

17. Verfahren gemäß dem vorangehenden Anspruch, **dadurch gekennzeichnet, dass** während der Opferoxidation eine Vorrichtung implementiert wird, die mehrere Heizlampen umfasst, die auf verschiedene Stellen der Schicht ausgerichtet sind und selektiv betrieben werden können, um die Temperatur, bei der die Schicht oxidiert wird, lokal einzustellen.

18. Verfahren nach einem der vorangehenden Ansprüche, **dadurch gekennzeichnet, dass** es auch die Schritte einer Schichttransfertechnik implementiert.

19. Verfahren gemäß einem der vorangehenden Ansprüche, bei dem das Ableiten (1052') von Dickenkorrekturspezifikationen umfasst:
- Erstellen eines Dickenprofils der Schicht auf der Basis der gewonnenen Dickenmessungen;
- Vergleichen des Profils mit gespeicherten typischen Profilen, wobei jedes typisches Profil verknüpft mit jeweiligen Dickenkorrekturspezifikationen oder Verfahrensanweisungen gespeichert ist; und
- Auswählen eines gespeicherten typischen Profils, um eine Schicht, deren Dicke zu korrigieren ist, mit den Dickenkorrekturspezifikationen zu verknüpfen, die verknüpft mit dem ausgewählten typischen Profil gespeichert sind.

20. Verfahren gemäß dem vorangehenden Anspruch, **dadurch gekennzeichnet, dass** das Verfahren einen Konfigurationsschritt umfasst, der das Aufstellen von Verknüpfungen zwischen den gespeicherten typischen Profilen und den Verfahrensanweisungen ermöglicht.

21. Verfahren gemäß dem vorangehenden Anspruch, **dadurch gekennzeichnet, dass** die Konfiguration durch einen Algorithmus implementiert wird, der als ein Eingangsdatenelement eine Zielspezifikation für ein Dickenprofil aufweist, die für eine Schichtherstellung aufgestellt wurde.

22. Verfahren gemäß dem vorangehenden Anspruch, **dadurch gekennzeichnet, dass** die Dickenmessungen, die typischen Profile und das Ziel unter Verwendung identischer Netze definiert werden.

23. Verfahren gemäß einem der beiden vorangehenden Ansprüche, **dadurch gekennzeichnet, dass** bei jeder Zieländerung der Konfigurationsalgorithmus automatisch neu aktiviert wird, um eine neue Konfiguration zu erstellen, die Entsprechungen zwischen den typischen Profilen und den Verfahrensanweisungen definiert.

24. Verfahren gemäß einem der vier vorangehenden Ansprüche, **dadurch gekennzeichnet, dass** das Verfahren das Speichern wenigstens einer Konfiguration umfasst.

25. Verfahren gemäß einem der sechs vorangehenden Ansprüche, **dadurch gekennzeichnet, dass** das Verfahren das Speichern mehrerer Konfigurationen und das Auswählen einer gewünschten Konfiguration umfasst.

26. Verfahren gemäß einem der sieben vorangehenden Ansprüche, **dadurch gekennzeichnet, dass** die typischen Profile und/oder die Verfahrensanweisungen in einer Baumstruktur klassifiziert sind, die Kategorien und Unterkategorien mit einer gewünschten Anzahl von Ebenen definiert.

27. Verfahren gemäß dem vorangehenden Anspruch, **dadurch gekennzeichnet, dass** Bereiche der Baumstruktur der typischen Profile ausgewählt werden können, innerhalb derer eine Suche unternommen werden kann, um ein typisches Profil auszuwählen.

28. Verfahren gemäß einem der beiden vorangehenden Ansprüche, **dadurch gekennzeichnet, dass** die Baumstruktur der Verfahrensanweisungen durch feinere und feinere, tiefer in die Baumstruktur hineingehende Detailebenen definiert ist.

29. Verfahren gemäß dem vorangehenden Anspruch in Kombination mit Anspruch 21, **dadurch gekennzeichnet, dass,** um eine Konfiguration zu erstellen, der Konfigurationsalgorithmus, der nach einer Verfahrensanweisung zum Verknüpfen mit einem typischen Profil sucht, nicht alle der Verfahrensanweisungen durchsucht, sondern mit dem Auswählen von Verfahrensanweisungskategorien als Funktion der Dickenunterschiede zwischen dem Ziel und dem typischen Profil beginnt.

30. Verfahren gemäß einem der vier vorangehenden Ansprüche in Kombination mit Anspruch 21, **dadurch gekennzeichnet, dass** für Konfigurationszwecke eine Verbindung zwischen einer vorgegebenen Startebene einer Baumstruktur der typischen Profile und einer vorgegebenen Ankunftsebene einer Baumstruktur der Verfahrensanweisungen hergestellt wird, so dass für jedes typische Profil, das zu einer gegebenen Startebenenkategorie gehört, eine Ankunftsebenenkategorie von Verfahrensanweisungen vorhanden ist, und dass während einer Konfiguration alles Suchen nach einer Verfahrensanweisung für ein typisches Profil auf dieser Startebene automatisch zur Ankunftsebenenkategorie geleitet wird, wobei die Suche dann durch tieferes Hineingehen in die Verfahrensanweisungs-Baumstruktur fortgesetzt wird.

31. Verfahren gemäß einem der beiden vorangehenden Ansprüche, **dadurch gekennzeichnet, dass** die Verfahrensanweisungs-Baumstruktur durch Verfahrensanweisungs-Parameter definiert ist.

32. Verfahren gemäß dem vorangehenden Anspruch, **dadurch gekennzeichnet, dass** die Verfahrensanweisungskategorien hoher Ebene in der Verfahrensanweisungs-Baumstruktur umfassen:
- eine erste Verfahrensanweisungskategorie hoher Ebene, die eine einheitliche Dickenkorrekturspezifikation für die gesamte Oberfläche der Schicht definiert; und
- andere Kategorien hoher Ebene, die von Gesamtverteilungsparametern für Dickenkorrekturspezifikationen über die Oberfläche abhängen.

33. Verfahren gemäß einem der vierzehn vorangehenden Ansprüche, **dadurch gekennzeichnet, dass** die Dickenkorrektur gleichzeitig auf die gesamte Oberfläche einer Schicht angewendet wird, wobei es möglich ist, zu veranlassen, dass die Korrektur in Abhängigkeit von Positionen auf der Oberfläche der Schicht variiert.

34. Verfahren gemäß einem der fünfzehn vorangehenden Ansprüche, **dadurch gekennzeichnet, dass** Schichten gruppenweise behandelt werden, wobei die Dicke einer Schicht in einer Gruppe gemessen wird, während die Dicke einer Schicht in der Gruppe korrigiert wird, die der gemessenen Schicht um einen vorgegebenen Abstand vorangeht.

35. Verfahren gemäß dem vorangehenden Anspruch, **dadurch gekennzeichnet, dass** die Schichten in einer vorgegebenen Gruppe dieselbe endgültige Zieldicke teilen, und dass die Verfahrensanweisung für jede Schicht derart individualisiert wird, dass sichergestellt wird, dass, wenn die Dickenkorrektur durchgeführt wurde, eine mittlere Schichtdicke für die Gruppe erhalten wird, die so nahe wie möglich an dem gemeinsamen Ziel liegt.

36. Verfahren gemäß einem der siebzehn vorangehenden Ansprüche, **dadurch gekennzeichnet, dass** die Verfahrensanweisungen einer Dickenmodifikation entsprechen, die über die gesamte Schicht einheitlich ist.

37. Verfahren gemäß einem der achtzehn vorangehenden Ansprüche, **dadurch gekennzeichnet, dass** die Verfahrensanweisungen einer unterschiedlichen Dickenmodifikation über die Oberfläche der Schicht entsprechen.

38. Verwendung eines Verfahrens gemäß einem der vorangehenden Ansprüche zum Herstellen einer Halbleiterschicht in einer mehrschichtigen Struktur.

39. Verwendung gemäß dem vorangehenden Anspruch, **dadurch gekennzeichnet, dass** die Schicht aus Silizium ist.

40. Verwendung gemäß einem der beiden vorangehenden Ansprüche, **dadurch gekennzeichnet, dass** die mehrschichtige Struktur eine SOI-Struktur ist.

41. Gerät zum Implementieren eines Verfahrens gemäß einem der Ansprüche 1 bis 37, wobei das Gerät **dadurch gekennzeichnet ist, dass** es ein Mittel zum Gewinnen einer Dickenprofilmessung für eine Schicht sowie ein Mittel zum Korrigieren einer Schichtdicke durch Opferoxidation umfasst, das gleichzeitig die gesamte Oberfläche der Schicht behandelt, während die Schichtdicke in verschiedenen Bereichen der Schichtoberfläche gemäß empfangenen Dickenkorrekturspezifikationen lokal und selektiv angepasst wird.

42. Gerät gemäß dem vorangehenden Anspruch, **dadurch gekennzeichnet, dass** es außerdem eine Prozessoreinheit umfasst, die mit dem Messgewinnungsmittel und dem Dickenkorrekturmittel verbunden ist.

43. Gerät nach dem vorangehenden Anspruch, **dadurch gekennzeichnet, dass** das Mittel zum Gewinnen einer Dickenprofilmessung, das Dickenkorrektunnittel und die Prozessoreinheit in das Gerät integriert sind.

44. Gerät gemäß einem der drei vorangehenden Ansprüche, **dadurch gekennzeichnet, dass** das Mittel zum Gewinnen einer Dickenmessung ein Reflektometer anwendet.

45. Gerät gemäß einem der vier vorangehenden Ansprüche, **dadurch gekennzeichnet, dass** das Dickenkorrekturmittel zum Korrigieren der Dicke jeweils einer einzelnen Schicht ausgelegt ist.

46. Gerät gemäß einem der Ansprüche 41 bis 44, **dadurch gekennzeichnet, dass** das Dickenkorrekturmittel die Korrektur der Dicke ganzer Gruppen von Schichten ermöglicht.

47. Gerät gemäß dem vorangehenden Anspruch, **dadurch gekennzeichnet, dass** das Dickenkorrekturmittel ein Rohrofen ist.

48. Gerät gemäß einem der Ansprüche 41 bis 43, **dadurch gekennzeichnet, dass** das Mittel zum Gewinnen einer Dickenmessung ein Ellipsometer umfasst.

## Revendications

1. Procédé pour préparer une couche mince (201) de matériau semi-conducteur, le procédé comprenant une étape (1050') consistant à corriger l'épaisseur de la couche, ladite étape de correction d'épaisseur de la couche (201) elle-même comprenant les opérations suivantes consistant à :
acquérir (1051') un profil d'épaisseur mesuré (60) de la couche ;
déduire (1052') les spécifications de correction d'épaisseur (40) à partir du profil d'épaisseur mesuré (60) ; et
corriger (1053') l'épaisseur de la couche selon lesdites spécifications ;
le procédé étant **caractérisé en ce que** la correction d'épaisseur (1053') met en oeuvre une technique qui traite simultanément toute la surface de la couche, tout en adaptant localement et sélectivement l'épaisseur de couche dans différentes régions de la surface de couche, ladite technique mettant en oeuvre une oxydation sacrificielle.

2. Procédé selon la revendication précédente, **caractérisé en ce que** les spécifications de correction d'épaisseur (40) correspondent à la correction d'épaisseur uniforme (1053') sur la surface de la couche (201) à préparer.

3. Procédé selon la revendication 1 ou 2, **caractérisé en ce que** les spécifications de correction d'épaisseur (40) correspondent à une correction d'épaisseur différentielle (1053') sur la surface de la couche (201) à préparer.

4. Procédé selon l'une quelconque des revendications précédentes, **caractérisé en ce que** les spécifications de correction d'épaisseur (40) correspondent à la correction d'épaisseur uniforme (1053') sur la surface de la couche à préparer en combinaison avec la correction d'épaisseur différentielle (1053') sur la surface de la couche (201) à préparer.

5. Procédé selon l'une quelconque des revendications précédentes, **caractérisé en ce que** les spécifications de correction d'épaisseur (40) sont établies afin de produire une couche (201) avec une variation minimum de son épaisseur sur toute la couche (201).

6. Procédé selon l'une quelconque des revendications précédentes, **caractérisé en ce que** les couches sont préparées en lots de couches.

7. Procédé selon l'une quelconque des revendications précédentes, **caractérisé en ce que** la correction d'épaisseur de couche est réalisée sur des lots de couches.

8. Procédé selon l'une quelconque des deux revendications précédentes, **caractérisé en ce que** les couches d'un lot sont organisées dans une succession de couches, avec l'épaisseur d'une couche dans le lot qui est mesurée (1051') alors que l'épaisseur d'une couche précédente dans le même lot est corrigée (1053').

9. Procédé selon la revendication 6 ou la revendication 7, **caractérisé en ce que** pour la totalité des couches du lot, on définit un seul profil d'épaisseur cible (30) et les spécifications de correction d'épaisseur (40) respectives pour chacune des couches du lot sont individualisées de sorte que, une fois que la correction d'épaisseur a été réalisée, chaque couche du lot a un profil d'épaisseur de couche final qui est proche du profil d'épaisseur cible (30).

10. Procédé selon l'une quelconque des revendications 6 à 8, **caractérisé en ce que** pour la totalité des couches du lot, on définit un seul profil d'épaisseur cible, et les spécifications de correction d'épaisseur pour la totalité des couches du lot sont les mêmes, en fonction d'au moins une mesure d'épaisseur réalisée sur une couche du lot.

11. Procédé selon l'une quelconque des deux revendications précédentes, **caractérisé en ce que** le profil d'épaisseur cible (30) se compose d'une valeur cible, ladite valeur cible désignant une seule épaisseur cible à obtenir sur toute la surface de chacune des couches du lot.

12. Procédé selon l'une quelconque des revendications précédentes, **caractérisé en ce que** l'opération (1051') consistant à acquérir une mesure est réalisée avec un ellipsomètre.

13. Procédé selon l'une quelconque des revendications 1 à 11, **caractérisé en ce que** l'opération (1051') consistant à acquérir une mesure est réalisée avec un réflectomètre.

14. Procédé selon l'une quelconque des revendications précédentes, **caractérisé en ce que** l'oxydation sacrificielle est mise en oeuvre par une technique d'oxydation thermique.

15. Procédé selon les revendications précédentes, **caractérisé en ce que** l'oxydation sacrificielle est mise en oeuvre par une technique d'oxydation thermique rapide.

16. Procédé selon l'une quelconque des revendications précédentes, **caractérisé en ce que,** pendant l'oxydation sacrificielle, on met en oeuvre des moyens pour oxyder sélectivement différents emplacements de la couche.

17. Procédé selon la revendication précédente, **caractérisé en ce que,** pendant l'oxydation sacrificielle, on met en oeuvre un appareil comprenant une pluralité de lampes d'un dispositif de chauffage situées en face des différents emplacements de la couche et pouvant être alimentées sélectivement pour ajuster localement la température à laquelle la couche est oxydée.

18. Procédé selon l'une quelconque des revendications précédentes, **caractérisé en ce qu'**il met également en oeuvre les étapes d'une technique de transfert de couche.

19. Procédé selon l'une quelconque des revendications précédentes, dans lequel le procédé comprend les étapes consistant à :
déduire (1052') des spécifications de correction d'épaisseur ;
établir un profil d'épaisseur de la couche en fonction des mesures d'épaisseur acquises ;
comparer ledit profil avec les profils typiques stockés, chaque profil typique étant stocké en association à des spécifications ou recettes de correction d'épaisseur respectives ; et
sélectionner un profil typique stocké afin d'associer une couche dont l'épaisseur doit être corrigée avec les spécifications de correction d'épaisseur qui sont stockées en association avec le profil typique sélectionné.

20. Procédé selon la revendication précédente, **caractérisé en ce que** le procédé comprend une étape de configuration consistant à permettre d'établir des associations entre les profils typiques stockés et les recettes.

21. Procédé selon la revendication précédente, **caractérisé en ce que** ladite configuration est mise en oeuvre par un algorithme ayant, en tant qu'élément de données d'entrée, une spécification cible pour le profil d'épaisseur établi pour la fabrication de la couche.

22. Procédé selon la revendication précédente, **caractérisé en ce que** les mesures d'épaisseur, les profils typiques et la cible sont définis en utilisant des mailles identiques.

23. Procédé selon l'une quelconque des deux revendications précédentes, **caractérisé en ce que** à chaque changement de cible, l'algorithme de configuration est automatiquement réactivé pour établir une nouvelle configuration définissant des correspondances entre les profils typiques et les recettes.

24. Procédé selon l'une quelconque des quatre revendications précédentes, **caractérisé en ce que** le procédé comprend l'étape consistant à mémoriser au moins une configuration.

25. Procédé selon l'une quelconque des six revendications précédentes, **caractérisé en que** le procédé comprend les étapes consistant à mémoriser une pluralité de configurations, et à sélectionner une configuration souhaitée.

26. Procédé selon l'une quelconque des sept revendications précédentes, **caractérisé en ce que** les profils typiques et/ou les recettes sont classés dans une arborescence définissant des catégories et des sous-catégories avec un nombre souhaité de niveaux.

27. Procédé selon la revendication précédente, **caractérisé en ce que** l'on peut sélectionner des zones de l'arborescence de profil typique dans lesquelles entreprendre une recherche afin de sélectionner un profil typique.

28. Procédé selon l'une quelconque des deux revendications précédentes, **caractérisé en ce que** l'arborescence de recette est définie par des niveaux de détail de plus en plus fins en allant plus en profondeur dans l'arborescence.

29. Procédé selon la revendication précédente prise en combinaison avec la revendication 21, **caractérisé en ce qu'**afin d'établir une configuration, l'algorithme de configuration recherchant une recette pour s'associer à un profil typique ne recherche pas dans toutes les recettes, mais commence par sélectionner les catégories de recette en fonction des différences d'épaisseur entre le profil cible et le profil typique.

30. Procédé selon l'une quelconque des quatre revendications précédentes prises en combinaison avec la revendication 21, **caractérisé en ce que** pour des buts de configuration, un lien est établi entre un niveau de départ donné d'une arborescence de profil typique et un niveau d'arrivée donné d'une arborescence de recette, **en ce que** pour chaque profil typique appartenant à une catégorie donnée de niveau de départ, il existe une catégorie de recettes de niveau d'arrivée et pendant la configuration, toute la recherche pour une recette pour un profil typique à ce niveau de départ est automatiquement dirigée vers ladite catégorie de niveau d'arrivée, recherchant alors à continuer en allant plus en profondeur dans l'arborescence de la recette.

31. Procédé selon l'une quelconque des deux revendications précédentes, **caractérisé en ce que** l'arborescence de recette est définie par des paramètres de recette.

32. Procédé selon la revendication précédente, **caractérisé en ce que** les catégories de haut niveau de recettes dans l'arborescence de recette comprennent :
une première catégorie de recette à haut niveau définissant une spécification de correction d'épaisseur uniforme pour toute la surface de la couche ; et
d'autres catégories de haut niveau dépendant des paramètres de distribution d'ensemble pour les spécifications de correction d'épaisseur sur ladite surface.

33. Procédé selon l'une quelconque des quatorze revendications précédentes, **caractérisé en ce que** la correction d'épaisseur est appliquée simultanément sur toute la surface d'une couche, avec la possibilité d'amener ladite correction à différer en fonction de l'emplacement sur la surface de la couche.

34. Procédé selon l'une quelconque des quinze revendications précédentes, **caractérisé en ce que** les couches sont traitées par lots, l'épaisseur d'une couche dans un lot étant mesurée tout en corrigeant l'épaisseur d'une couche dans ledit lot précédant ladite couche mesurée par un pas donné.

35. Procédé selon la revendication précédente, **caractérisé en ce que** les couches dans un lot donné partagent la même épaisseur cible finale, et la recette pour chaque couche est individualisée afin de garantir qu'une fois que la correction d'épaisseur a été réalisée, on obtient une épaisseur de couche moyenne pour le lot qui est aussi proche que possible de la cible commune.

36. Procédé selon l'une quelconque des dix-sept revendications précédentes, **caractérisé en ce que** les recettes correspondent à la modification d'épaisseur qui est uniforme sur toute la couche.

37. Procédé selon l'une quelconque des dix-huit revendications précédentes, **caractérisé en ce que** les recettes correspondent à la modification d'épaisseur différentielle sur la surface de la couche.

38. Utilisation d'un procédé selon l'une quelconque des revendications précédentes pour fabriquer une couche de matériau semi-conducteur dans une structure à plusieurs couches.

39. Utilisation selon l'une quelconque des revendications précédentes, **caractérisée en ce que** ladite couche est réalisée à partir de silicium.

40. Utilisation selon l'une quelconque des deux revendications précédentes, **caractérisée en ce que** la structure à plusieurs couches est une structure SOI.

41. Machine pour mettre en oeuvre un procédé selon l'une quelconque des revendications 1 à 37, la machine étant **caractérisée en ce qu'**elle comprend des moyens pour acquérir une mesure de profil d'épaisseur pour une couche, et des moyens pour corriger l'épaisseur de couche par l'oxydation sacrificielle, qui traite simultanément toute la surface de la couche, tout en adaptant localement et sélectivement l'épaisseur de couche dans les différentes régions de la surface de couche, selon les spécifications de correction d'épaisseur reçues.

42. Machine selon la revendication précédente, **caractérisée en ce qu'**elle comprend en outre une unité de processeur raccordée aux moyens d'acquisition de mesure et aux moyens de correction d'épaisseur.

43. Machine selon la revendication précédente, **caractérisée en ce que** lesdits moyens pour acquérir une mesure de profil d'épaisseur, lesdits moyens de correction d'épaisseur et ladite unité de processeur sont intégrés dans la machine.

44. Machine selon l'une quelconque des trois revendications précédentes, **caractérisée en ce que** les moyens pour acquérir une mesure d'épaisseur mettent en oeuvre un réflectomètre.

45. Machine selon l'une quelconque des quatre revendications précédentes, **caractérisée en ce que** les moyens de correction d'épaisseur sont adaptés pour corriger l'épaisseur d'une seule couche à la fois.

46. Machine selon l'une quelconque des revendications 41 à 44, **caractérisée en ce que** les moyens de correction d'épaisseur permettent de corriger l'épaisseur de tous les lots de couches.

47. Machine selon la revendication précédente, **caractérisée en ce que** les moyens de correction d'épaisseur sont un four tubulaire.

48. Machine selon l'une quelconque des revendications 41 à 43, **caractérisée en ce que** les moyens pour acquérir une mesure d'épaisseur comprennent un ellipsomètre.
